# EUROPEAN PATENT APPLICATION

(11) **EP 4 303 941 A1**
(43) Date of publication of application: **10.01.2024**
(21) Application number: 22763032.4
(22) Date of filing: 21.02.2022
(51) Int. Cl.: H01L 33/62, G09F 9/33, H01L 33/50, H01L 33/60

(54) **LIGHT-EMITTING DEVICE AND METHOD FOR MANUFACTURING LIGHT-EMITTING DEVICE**

(30) Priority: 05.03.2021 JP 2021035604
(71) Applicant: Sony Semiconductor Solutions Corporation, Atsugi-shi, Kanagawa 243-0014 (JP)
(72) Inventor: MIURA, Toshihiro, Atsugi-shi, Kanagawa 243-0014 (JP); HASEGAWA, Toshiaki, Atsugi-shi, Kanagawa 243-0014 (JP); SASAKI, Toru, Atsugi-shi, Kanagawa 243-0014 (JP); KASHIHARA, Hiroyuki, Atsugi-shi, Kanagawa 243-0014 (JP)
(74) Representative: D Young & Co LLP
(86) International application number: PCT/JP2022/007037
(87) International publication number: WO 2022/185976

(57) **Abstract**

A light emitting device includes a substrate and a light emitting body. The light emitting body includes a plurality of light emitting elements and an insulating body in which the plurality of light emitting elements is embedded except for a light emitting surface of the plurality of light emitting elements. The plurality of light emitting elements is formed from a singulated compound semiconductor layer and is arranged in a row direction and a column direction. The substrate includes a drive circuit, a first terminal, and a second terminal and is joined to the light emitting body. The drive circuit drives the plurality of light emitting elements. The first terminal and the second terminal electrically couple the drive circuit and the plurality of light emitting elements to each other.

## Description

### Technical Field

The present disclosure relates to a light emitting device and a method of manufacturing a light emitting device.

### Background Art

PTL 1 discloses an image display element and a method of manufacturing the same. The image display element is configured such that a plurality of micro light emitting elements is arranged on a drive circuit substrate in a two-dimensional array shape. The micro light emitting element is a light-emitting diode (LED) including a compound semiconductor.

In a method of manufacturing the image display element, a compound semiconductor is formed on a growth substrate through epitaxial growth. The compound semiconductor is divided into a plurality of pieces on the growth substrate, and electrodes and the like are formed at the plurality of compound semiconductors to form a plurality of micro light emitting elements. In addition, the growth substrate is caused to be opposed to the drive circuit substrate, and the plurality of micro light emitting elements on the growth substrate is joined to the drive circuit substrate. After they are joined, the growth substrate is removed.

### Citation List

### Patent Literature

PTL 1: Japanese Unexamined Patent Application Publication No. 2020-88383

### Summary of the Invention

Incidentally, crystal defects are more likely to occur at a compound semiconductor formed through epitaxial growth. Thus, from the viewpoint of yielding during manufacturing, a small-sized growth substrate is used. For example, a growth substrate having a size equal to or less than 6 inches is used. Thus, it is desired to develop a large-sized light emitting device having a size larger than that of the growth substrate.

The present disclosure provides a light emitting device that makes it possible to achieve an increase in size, and a method of manufacturing the light emitting device.

A light emitting device according to an embodiment of the present disclosure includes a light emitting body and a substrate. The light emitting body includes a plurality of light emitting elements and an insulating body in which the plurality of light emitting elements is embedded except for a light emitting surface of the plurality of light emitting elements. The plurality of light emitting elements is formed from a singulated compound semiconductor layer and is arranged in a row direction and a column direction. The substrate includes a drive circuit, a first terminal, and a second terminal and is joined to the light emitting body. The drive circuit drives the plurality of light emitting element. The first terminal and the second terminal electrically couple the drive circuit and the plurality of light emitting element to each other.

A method of manufacturing a light emitting device according to an embodiment of the present disclosure includes: forming a compound semiconductor layer obtained by causing a first compound semiconductor layer, an active layer, and a second compound semiconductor layer to sequentially grow on a growth substrate; forming a singulated compound semiconductor layer by dicing the growth substrate and the compound semiconductor layer; causing the second compound semiconductor layer to be opposed to a first joining surface of a first support substrate and joining the compound semiconductor layer to the first joining surface; peeling off the growth substrate; causing the first compound semiconductor layer to be opposed to a second joining surface of a second support substrate and joining the compound semiconductor layer to the second joining surface; removing the first support substrate; forming a plurality of light emitting elements from the singulated compound semiconductor layer; forming a light emitting body by forming an insulating body around the plurality of light emitting elements on the second support substrate; joining the second support substrate to a substrate on which a drive circuit, to which a first terminal and a second terminal are coupled, is mounted, in a state where the light emitting body is interposed between the substrate and the second support substrate and the second compound semiconductor layer is electrically coupled to the second terminal; removing the second support substrate; and electrically coupling the first compound semiconductor layer and the first terminal to each other.

### Brief Description of Drawings

[FIG. 1] FIG. 1 is a schematic cross-sectional view of a light emitting device according to a first embodiment of the present disclosure.
[FIG. 2] FIG. 2 is an enlarged cross-sectional view in which a main part of the light emitting device illustrated in FIG. 1 is enlarged.
[FIG. 3] FIG. 3 is an enlarged main-part cross-sectional view in which a part between light emitting elements of the light emitting device illustrated in FIG. 2 is further enlarged.
[FIG. 4] FIG. 4 is a plan view of a transparent electrode of the light emitting device illustrated in FIGs. 1 and 2.
[FIG. 5] FIG. 5 is a plan view of a reflection attenuating film corresponding to FIG. 4 of the light emitting device illustrated in FIGs. 1 and 2.
[FIG. 6] FIG. 6 is an enlarged cross-sectional view in which a main part of the light emitting device illustrated in FIG. 1 is enlarged.
[FIG. 7A] FIG. 7A is a cross-sectional view of a first process, describing a method of manufacturing the light emitting device according to the first embodiment.
[FIG. 7B] FIG. 7B is a cross-sectional view in which a main part of the cross-sectional view of the first process illustrated in FIG. 7A is enlarged.
[FIG. 8] FIG. 8 is a cross-sectional view of a second process.
[FIG. 9A] FIG. 9A is a cross-sectional view of a third process.
[FIG. 9B] FIG. 9B is a cross-sectional view in which a main part of the cross-sectional view of the third process illustrated in FIG. 9A is enlarged.
[FIG. 10A] FIG. 10A is a cross-sectional view of a fourth process.
[FIG. 10B] FIG. 10B is a cross-sectional view in which a main part of the cross-sectional view of the fourth process illustrated in FIG. 10A is enlarged.
[FIG. 11] FIG. 11 is a cross-sectional view of a fifth process.
[FIG. 12] FIG. 12 is a cross-sectional view of a sixth process.
[FIG. 13A] FIG. 13A is a cross-sectional view of a seventh process.
[FIG. 13B] FIG. 13B is a cross-sectional view in which a main part of the cross-sectional view of the seventh process illustrated in FIG. 13A is enlarged.
[FIG. 14] FIG. 14 is a cross-sectional view of an eighth process, corresponding to FIG. 7B.
[FIG. 15] FIG. 15 is a cross-sectional view of a ninth process, corresponding to FIG. 7B.
[FIG. 16] FIG. 16 is a cross-sectional view of a tenth process, corresponding to FIG. 7B.
[FIG. 17] FIG. 17 is a cross-sectional view of an eleventh process, corresponding to FIG. 7B.
[FIG. 18] FIG. 18 is a cross-sectional view of a twelfth process, corresponding to FIG. 7B.
[FIG. 19] FIG. 19 is a cross-sectional view of a thirteenth process, corresponding to FIG. 7B.
[FIG. 20] FIG. 20 is a cross-sectional view of a fourteenth process, corresponding to FIG. 7B.
[FIG. 21] FIG. 21 is a cross-sectional view of a fifteenth process, corresponding to FIG. 7B.
[FIG. 22] FIG. 22 is a cross-sectional view of a sixteenth process, corresponding to FIG. 7B.
[FIG. 23] FIG. 23 is a cross-sectional view of a seventeenth process, corresponding to FIG. 7B.
[FIG. 24] FIG. 24 is a cross-sectional view of an eighteenth process, corresponding to FIG. 7B.
[FIG. 25] FIG. 25 is a cross-sectional view of a nineteenth process, corresponding to FIG. 7B.
[FIG. 26] FIG. 26 is a cross-sectional view of a twentieth process, corresponding to FIG. 7B.
[FIG. 27] FIG. 27 is an enlarged cross-sectional view of a light emitting device according to a second embodiment of the present disclosure, corresponding to FIG. 2.
[FIG. 28] FIG. 28 is an enlarged main-part cross-sectional view of a light emitting device according to a third embodiment of the present disclosure, corresponding to FIG. 3.
[FIG. 29] FIG. 29 is an enlarged main-part cross-sectional view of a light emitting device according to a fourth embodiment of the present disclosure, corresponding to FIG. 3.
[FIG. 30] FIG. 30 is an enlarged main-part cross-sectional view of a light emitting device according to a fifth embodiment of the present disclosure, corresponding to FIG. 3.
[FIG. 31] FIG. 31 is an enlarged main-part cross-sectional view of a light emitting device according to a sixth embodiment of the present disclosure, corresponding to FIG. 3.
[FIG. 32] FIG. 32 is an enlarged cross-sectional view of a light emitting device according to a seventh embodiment of the present disclosure, corresponding to FIG. 2.
[FIG. 33] FIG. 33 is an enlarged cross-sectional view of a light emitting device according to an eighth embodiment of the present disclosure, corresponding to FIG. 2.
[FIG. 34] FIG. 34 is an enlarged cross-sectional view of a light emitting device according to a ninth embodiment of the present disclosure, corresponding to FIG. 6.
[FIG. 35] FIG. 35 is an elevation view of an example of an appearance of a digital still camera which is a first application example of the light emitting device of the present disclosure.
[FIG. 36] FIG. 36 is a back view of an example of the appearance of the digital still camera illustrated in FIG. 35.
[FIG. 37] FIG. 37 is a perspective view of an example of an appearance of a head-mounted display which is a second application example of the light emitting device of the present disclosure.
[FIG. 38] FIG. 38 is a perspective view of an example of an appearance of a television apparatus which is a third application example of the light emitting device of the present disclosure.

### Modes for Carrying Out the Invention

Below, embodiments according to the present disclosure will be described in detail with reference to the drawings. Note that the description will be given in the following order.

### 1. First Embodiment

A first embodiment is an example in which the present technology is applied to a light emitting device and a method of manufacturing the light emitting device.

### 2. Second Embodiment

A second embodiment is an example in which a structure of coupling a light emitting element and a drive circuit in the light emitting device according to the first embodiment is modified.

### 3. Third to Sixth Embodiments

Third to sixth embodiments are examples in which a structure of a reflection attenuating film disposed between light emitting elements in the light emitting device according to the first embodiment is modified.

### 4. Seventh and Eighth Embodiments

Seventh and eighth embodiments are examples in which a separation structure of the light emitting element in the light emitting device according to the first embodiment is modified.

### 5. Ninth Embodiment

A ninth embodiment is an example in which a structure of a light shielding film in the light emitting device according to the first embodiment is modified.

### 6. First to Third Application Examples

A first application example is an example in which the present technology is applied to a digital still camera. A second application example is an example in which the present technology is applied to a head-mounted display. A third application example is an example in which the present technology is applied to a television apparatus.

Here, an arrowed X direction illustrated in the drawings on an as-necessary basis is one direction of a planar direction of a light emitting device, directed from the left side on a paper surface toward the right side. An arrowed Y direction is perpendicular to the arrowed X direction and is another direction of the planar direction of the light emitting device, directed from the paper surface front side toward a direction going behind the paper surface. In addition, an arrowed Z direction is perpendicular to the arrowed X direction and the arrowed Y direction, and is a height direction of the light emitting device from the bottom side of the paper surface toward the upper side. The arrowed X direction, the arrowed Y direction, and the arrowed Z direction correspond to an X-axis direction, a Y-axis direction, and a Z-axis direction, respectively, in a three-dimensional coordinate system.

Note that these directions are illustrated to help understand the present technology, and are not given for the purpose of limiting the direction of the present technology.

### <First Embodiment>

### [Configuration of Light Emitting Device 1]

### (1) Overall Schematic Configuration of Light Emitting Device 1

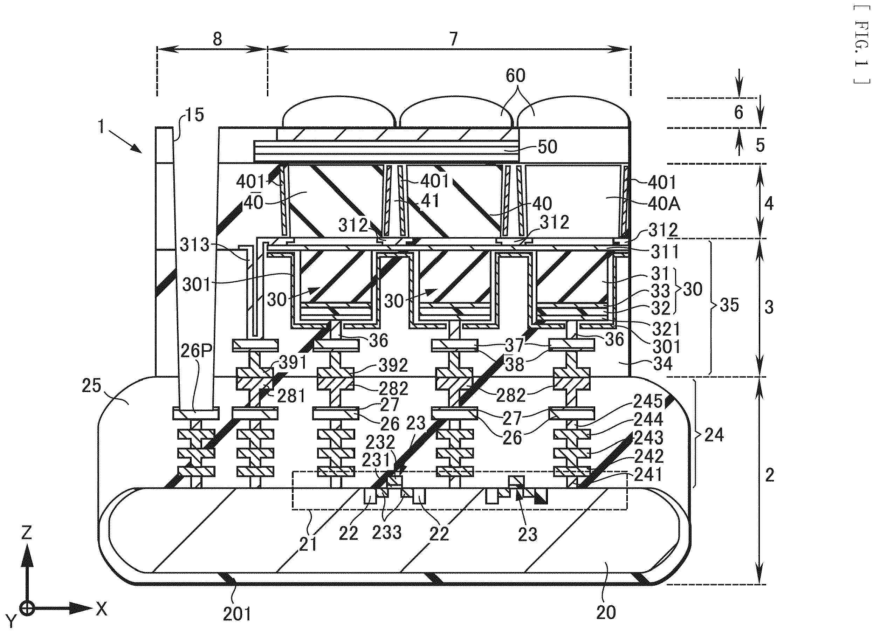

As illustrated in FIG. 1, a light emitting device 1 according to the first embodiment of the present technology includes a substrate region 2, a light emitting body region 3, a color conversion region 4, a filter region 5, and an optical system region 6, in a vertical cross-section direction that is the arrowed Z direction. In addition, the light emitting device 1 includes a device arrangement region 7 and a peripheral region 8 in a planar direction including the arrowed X direction and the arrowed Y direction.

Furthermore, the light emitting device 1 includes, as main components, a substrate 20 included in the substrate region 2, and a light emitting body 35 disposed in the light emitting body region 3 and including a plurality of light emitting elements 30 arranged in the device arrangement region 7.

### (2) Configuration of Substrate Region 2

The substrate region 2 is configured to include the substrate 20 and a drive circuit 21 mounted on a main surface of the substrate 20. Here, the main surface of the substrate 20 is one surface of the substrate 20 in which a semiconductor device such as a driving transistor is manufactured and the drive circuit 21 is formed.

For the substrate 20, a monocrystalline silicon (Si) substrate is used, for example. An insulating body 201 is provided on a rear surface of the substrate 20 located on an opposite side from the main surface, and also on side surfaces. For example, a silicon nitride (SiN) film or a silicon oxide (SiO) film may be practically used as the insulating body 201.

### (2-1) Configuration of Drive Circuit 21

The drive circuit 21 is configured with a semiconductor device provided at a main surface portion of the substrate 20. The semiconductor device includes a complementary insulated gate field effect transistor (IGFET) 23 as the driving transistor. The insulated gate field effect transistor 23 at least includes both a field effect transistor (MISFET) having a metal/insulating body/semiconductor structure and a field effect transistor (MOSFET) having a metal/oxide film/semiconductor structure.

FIG. 1 illustrates an n-channel conductive type insulated gate field effect transistor 23. The insulated gate field effect transistor 23 is provided at the main surface portion of the substrate 20 in a region having a periphery surrounded by a device isolation region 22. For example, a trench separation structure ( is used for the device isolation region 22. That is, the device isolation region 22 is configured to include a groove dug in a depth direction from the main surface of the substrate 20, and an insulating body embedded in the groove.

The insulated gate field effect transistor 23 is configured to include a channel formation region (substrate 20), a gate insulating film 231, a gate electrode 232, and paired n-type semiconductor regions 233 used as a source region and a drain region. The gate insulating film 231 is provided on the channel formation region. The gate electrode 232 is provided on the gate insulating film 231. The paired n-type semiconductor regions 233 are provided at main surface portions of the substrate 20 that are spaced apart in a channel length direction with the channel formation region being interposed therebetween.

Note that insulated gate field effect transistors of a p-channel conductive type differ only in terms of the conductive type of the semiconductor region, and the basic structure is the same. Thus, illustration of the insulated gate field effect transistor of the p-channel conductive type and explanation of the structure thereof will not be provided.

The drive circuit 21 is electrically coupled to each of a first terminal 281 and a second terminal 282 through a wiring layer 24. Here, the wiring layer 24 includes a plug wiring line 241, a first layer wiring line 242, a second layer wiring line 243, a third layer wiring line 244, and a plug wiring line 245.

The plug wiring line 241 is provided, for example, on the n-type semiconductor region 233 of the insulated gate field effect transistor 23, and one end (lower end) of the plug wiring line 241 is electrically coupled to the n-type semiconductor region 233. The plug wiring line 241 includes, for example, tungsten (W).

The first layer wiring line 242 is provided on the plug wiring line 241, and the first layer wiring line 242 is electrically coupled to another end (upper end) of the plug wiring line 241. The second layer wiring line 243 is provided on the first layer wiring line 242, and the second layer wiring line 243 is electrically coupled to the first layer wiring line 242. The third layer wiring line 244 is provided on the second layer wiring line 243, and the third layer wiring line 244 is electrically coupled to the second layer wiring line 243. The first layer wiring line 242 to the third layer wiring line 244 each include, for example, aluminum (Al) as a main composition.

In addition, an insulating body 25 is provided around the plug wiring line 241, between the first layer wiring line 242 and the second layer wiring line 243, between the second layer wiring line 243 and the third layer wiring line 244, and the like. The insulating body 25 includes, for example, a silicon oxide film or a silicon nitride film.

### (2-2) Configuration of Second Light Shielding Film 26 and Second Light Absorbing Film 27

The third layer wiring line 244 is electrically coupled to the first terminal 281 or the second terminal 282 sequentially through the plug wiring line 245, a second light shielding film 26, and a second light absorbing film 27.

The second light shielding film 26 is disposed on the light emitting element 30 side of the insulated gate field effect transistor 23 that constitutes the drive circuit 21. Here, ends of the second light shielding film 26 extend in the planar direction to above the insulated gate field effect transistor 23. The second light shielding film 26 is disposed within the insulating body 25. The second light shielding film 26 blocks leakage light emitted from the light emitting element 30 toward the drive circuit 21 side, and is formed as an electrical path that electrically couples the drive circuit 21 and each of the first terminal 281 and the second terminal 282 to each other.

The second light shielding film 26 includes a single metal layer film including, as a main composition, aluminum, copper (Cu), tungsten, or titanium (Ti), for example.

The second light absorbing film 27 is disposed on the second light shielding film 26. Here, the second light absorbing film 27 is formed to have the same planar shape as the planar shape of the second light shielding film 26 as viewed from a direction perpendicular to the main surface of the substrate 20 (hereinafter, simply referred to as "plan view"). The second light absorbing film 27 is disposed within the insulating body 25. The second light absorbing film 27 absorbs leakage light emitted from the light emitting element 30 toward the drive circuit 21 side, and is formed as an electrical path that electrically couples the drive circuit 21 and each of the first terminal 281 and the second terminal 282 to each other.

The second light absorbing film 27 includes a single layer film including metal or a metallic compound including, as a main composition, titanium (TiN), cobalt (Co), nitrogen-doped titanium oxide (TiON), tantalum nitride (TaN), or amorphous carbon (a-C), for example.

### (2-3) Configuration of First Terminal 281 and Second Terminal 282

The first terminal 281 and the second terminal 282 are disposed on the second light absorbing film 27 and also on the insulating body 25. Each of the first terminal 281 and the second terminal 282 is electrically coupled to the second light absorbing film 27.

The first terminal 281 is configured to be electrically coupled to one side (specifically, a first compound semiconductor layer 31) of the light emitting element 30. The second terminal 282 is configured to be electrically coupled to another side (specifically, a second compound semiconductor layer 32) of the light emitting element 30.

The first terminal 281 and the second terminal 282 include the same conductive material, for example, copper (Cu).

### (3) Configuration of Light Emitting Body Region 3

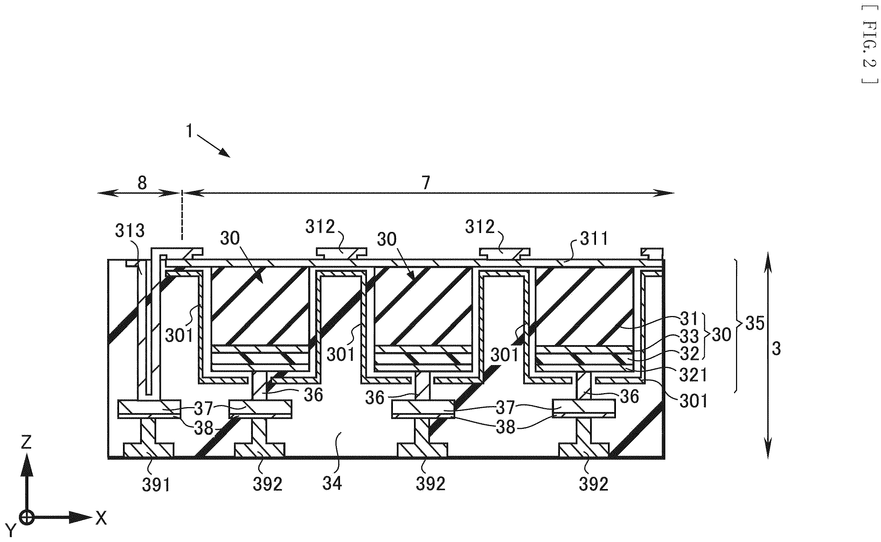

As illustrated in FIGs. 1 and 2, the light emitting body region 3 includes the light emitting body 35 disposed on the substrate region 2 and on the insulating body 25. Here, in the light emitting body 35, a plurality of light emitting elements 30 is arranged in a matrix along directions (the arrowed X direction and the arrowed Y direction) of the light emitting surface of the light emitting elements 30. The plurality of light emitting elements 30 is formed from a singulated compound semiconductor layer.

Here, the light emitting element 30 formed from the singulated compound semiconductor layer is a light emitting element formed from a compound semiconductor layer obtained by causing a compound semiconductor layer to grow on a growth substrate, dicing the growth substrate and the compound semiconductor layer, and separating them into individual divided pieces. The growth substrate singulated together with the compound semiconductor layer is removed in a manufacturing process. In the light emitting device 1 according to the present embodiment, one or a plurality of light emitting elements 30 is formed from the singulated compound semiconductor layer.

The light emitting body 35 further includes an insulating body 34 provided around the plurality of light emitting elements 30 except for the light emitting surface. The insulating body 34 includes, as a main composition, a silicon oxide film or a silicon nitride film.

### (3-1) Configuration of Light Emitting Element 30

The light emitting element 30 is configured as a light-emitting diode (LED) including the first compound semiconductor layer 31, the second compound semiconductor layer 32, and an active layer 33. The second compound semiconductor layer 32 is disposed on the substrate region 2 side. The light emitting element 30 includes, as a main composition, a III-V compound semiconductor, and the second compound semiconductor layer 32 includes, for example, a p-type gallium nitride (p-GaN). The first compound semiconductor layer 31 includes, for example, an n-type gallium nitride (n-GaN).

### (3-2) Configuration of First Light Reflecting Film 301

A first light reflecting film 301 is provided for each of the plurality of light emitting elements 30. The first light reflecting film 301 is provided to surround the light emitting element 30 along side surfaces of the first compound semiconductor layer 31, side surfaces of the active layer 33, side surfaces of the second compound semiconductor layer 32, and a surface, on the substrate region 2 side, of the second compound semiconductor layer 32. The first light reflecting film 301 is not provided on the light emitting surface that is a surface of the first compound semiconductor layer 31. The first light reflecting film 301 reflects, toward the light emitting surface side, light emitted from the light emitting element 30, thereby improving light extraction efficiency.

The first light reflecting film 301 has a constant film thickness along the side surfaces of the first compound semiconductor layer 31, the side surfaces of the active layer 33, the side surfaces of the second compound semiconductor layer 32, and the surface of the second compound semiconductor layer 32. To achieve this, the first light reflecting film 301 is formed by a chemical vapor deposition (CVD) method or an atomic layer deposition (ALD) method that provides favorable step coverage.

The first light reflecting film 301 includes, for example, metal such as aluminum or tungsten, or a metallic compound.

### (3-3) Configuration of Transparent Electrode 311

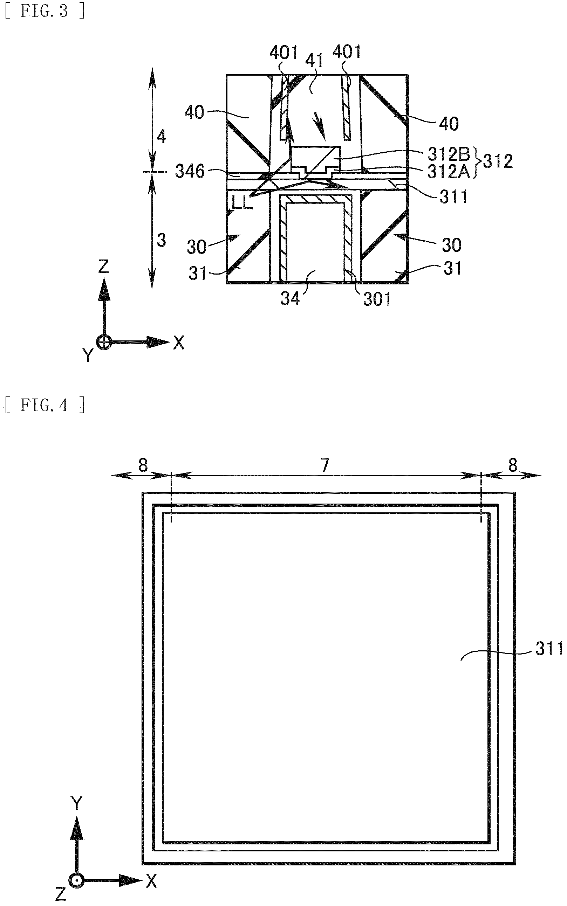

As illustrated in FIGs. 1 to 4, a transparent electrode 311 is provided on the first compound semiconductor layer 31 of the light emitting element 30, and the transparent electrode 311 is electrically coupled to the first compound semiconductor layer 31. The transparent electrode 311 is integrally formed using the same conductive material in the light emitting elements 30 adjacent in a direction of the light emitting surface. In other words, the transparent electrode 311 is configured in the device arrangement region 7 as a common electrode shared between all the light emitting elements 30. Here, the transparent electrode 311 has a rectangular shape in plan view, as illustrated in FIG. 4. The transparent electrode 311 includes, for example, indium tin oxide (ITO).

In the peripheral region 8, the transparent electrode 311 is electrically coupled to a first terminal 391 through a through wiring line 313. The through wiring line 313 is a wiring line extending in the thickness direction of the light emitting body 35 from the surface side of the light emitting body 35 toward the inside of the light emitting body 35. A specific material included in the through wiring line 313 will be described later.

At a position corresponding to the first terminal 281 of the substrate region 2, the first terminal 391 is provided at a surface, on the substrate region 2 side, of the light emitting body 35. The first terminal 391 is joined to and is electrically coupled to the first terminal 281. The first terminal 391 includes, for example, copper.

### (3-4) Configuration of Reflection Attenuating Film 312

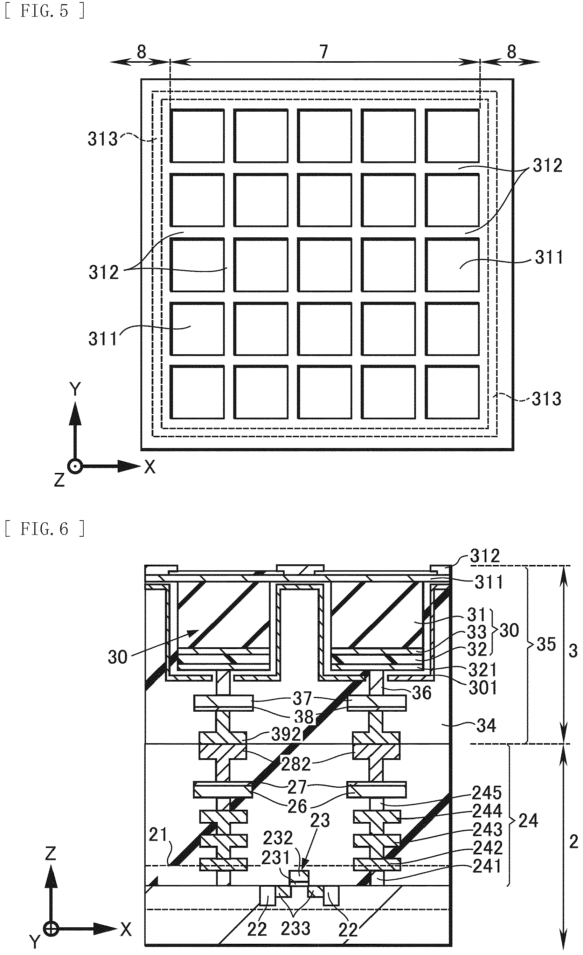

As illustrated in FIGs. 1 to 3 and 5, in the device arrangement region 7, a reflection attenuating film 312 is disposed on the transparent electrode 311 between the light emitting elements 30 to overlap with the transparent electrode 311. In plan view, the reflection attenuating film 312 has a rectangular shape as a whole, as with the transparent electrode 311, and has a lattice shape extending in the arrowed X direction and the arrowed Y direction between the light emitting elements 30 as illustrated in FIG. 5.

The reflection attenuating film 312 is set such that a reflectance thereof at an interface with the transparent electrode 311 is lower than a light reflectance at an interface between the transparent electrode 311 and an insulting material of the insulating body 34. In addition, the reflection attenuating film 312 is formed such that a light transmittance thereof is lower than a light transmittance of the transparent electrode 311. Furthermore, the reflection attenuating film 312 has electrical conductivity, and is electrically coupled to the transparent electrode 311.

In the first embodiment, the reflection attenuating film 312 includes a combined film including a titanium nitride film 312A and a tungsten film 312B stacked on the titanium nitride film 312A. Here, for example, when the transparent electrode 311 is set to have a thickness of greater than or equal to 10 nm and less than or equal to 100 nm, the titanium nitride film 312A is set to have a thickness of greater than or equal to 3 nm and less than or equal to 50 nm, and the tungsten film 312B is set to have a thickness of greater than or equal to 50 nm and less than or equal to 200 nm.

In addition, the reflection attenuating film 312 may include a single layer film including, as a main composition, one or more metals selected from aluminum, titanium, tungsten, and copper, or may include a combined film including two or more layers. Furthermore, the reflection attenuating film 312 may include a metallic compound including the above-described metal as a main composition.

As illustrated in FIGs. 1, 2, and 5, the transparent electrode 311 and the reflection attenuating film 312 are electrically coupled to the through wiring line 313 in the peripheral region 8. In the first embodiment, the through wiring line 313 includes the same conductive material as the reflection attenuating film 312, and is provided at the same conductive layer. That is, in a method of manufacturing the light emitting device 1, the through wiring line 313 is formed through the same manufacturing processes as those for the reflection attenuating film 312.

### (3-5) Configuration of Transparent Electrode 321

As illustrated in FIGs. 1, 2, and 6, a transparent electrode 321 is provided on the surface, on the substrate region 2 side, of the second compound semiconductor layer 32 of the light emitting element 30. The transparent electrode 321 is electrically coupled to the second compound semiconductor layer 32. The transparent electrode 321 is configured for each of the light emitting elements 30 such that the periphery of the transparent electrode 321 is surrounded by the first light reflecting film 301, and has a rectangular shape in plan view, as with the transparent electrode 311. In addition, the transparent electrode 321 includes, for example, indium tin oxide, as with the transparent electrode 311.

### (3-6) Configuration of Plug Wiring Line 36

In the device arrangement region 7, the transparent electrode 321 is electrically coupled to a second terminal 392 through a plug wiring line 36 provided directly below the transparent electrode 321 and for each of the light emitting elements 30. The plug wiring line 36 is a wiring line extending in the thickness direction of the light emitting body 35 from the surface side of the light emitting body 35 toward the inside of the light emitting body 35. One end portion of the plug wiring line 36 on the second compound semiconductor layer 32 side penetrates, in the thickness direction, through a portion of the first light reflecting film 301 provided along the second compound semiconductor layer 32, and is electrically coupled to the second compound semiconductor layer 32. Another end portion of the plug wiring line 36 on the substrate region 2 side is electrically coupled to the second terminal 392 with each of the first light absorbing film 37 and the first light shielding film 38 being interposed therebetween.

The plug wiring line 36 is formed by filling, with an electrically conductive material, a contact hole, without reference character, formed in the insulating body 34. That is, in plan view, the dimension of one end portion of the plug wiring line 36 matches the dimension of an opening of the contact hole. In a portion of the first light reflecting film 301 where the plug wiring line 36 penetrates through, the first light reflecting film 301 and the plug wiring line 36 are only necessary to be electrically separated from each other. Thus, in plan view, it is possible to set the dimension of the opening to be small. The plug wiring line 36 includes, for example, tungsten.

The second terminal 392 is provided at a position that corresponds to the second terminal 282 of the substrate region 2 at the surface of the light emitting body 35 on the substrate region 2 side. The second terminal 392 is joined to and is electrically coupled to the second terminal 282. The second terminal 392 includes, for example, copper, as with the first terminal 391.

### (3-7) Configuration of First Light Absorbing Film 37 and First Light Shielding Film 38

Between the first light reflecting film 301 and the second terminal 392 or the second terminal 282 of the substrate region 2, the first light absorbing film 37 is provided at an outer periphery intersecting with the direction (arrowed Z direction) in which the plug wiring line 36 extends, here, in a planar direction (the arrowed X direction and the arrowed Y direction) perpendicular to the direction (arrowed Z direction) in which the plug wiring line 36 extends. In plan view, the first light absorbing film 37 is set to have the same dimension as the dimension of the opening of the portion of the first light reflecting film 301 where the plug wiring line 36 penetrates through, or to have a dimension larger than this dimension of the opening. The first light absorbing film 37 absorbs leakage light from a portion between the first light reflecting film 301 and the plug wiring line 36 toward the substrate region 2 side, and is formed as an electrical path that electrically couples the plug wiring line 36 and the second terminal 392 to each other. The first light absorbing film 37 is provided within the insulating body 25.

The first light absorbing film includes, for example, the same electrically conductive material as the second light absorbing film.

The first light shielding film 38 is provided below the first light absorbing film 37. The first light shielding film 38 has the same planar shape as the planar shape of the first light absorbing film 37 in plan view. The first light shielding film 38 is provided within the insulating body 25. The first light shielding film 38 blocks leakage light emitted from the light emitting element 30 toward the drive circuit 21 side, and is further formed as an electrical path, as with the first light absorbing film 37.

The first light shielding film 38 includes, for example, the same electrically conductive material as the second light shielding film 26, and includes a single metal layer film including, for example, tungsten or cobalt as a main composition.

### (4) Configuration of Color Conversion Region 4

Returned to FIG. 1, the color conversion region 4 includes a color conversion layer 40 and a second light reflecting film 401. The color conversion layer 40 is provided on the light emitting surface of the light emitting element 30, in other word, is provided on the transparent electrode 311 with an insulating film 346 being interposed therebetween. The color conversion layer 40 is provided for each of the light emitting elements 30. The color conversion layer 40 converts light emitted from the light emitting element 30 into a particular color. Here, the light emitting device 1 is configured as a color light emitting device (or a color image display apparatus). The color conversion layer 40 includes, for example, a resin material.

The second light reflecting film 401 is provided along the periphery of side surfaces of the color conversion layer 40. The second light reflecting film 401 reflects light emitted from the light emitting element 30 and light diffused from the color conversion layer 40 to improve light extraction efficiency. The second light reflecting film 401 is formed, for example, using a method similar to that for the first light reflecting film 301, and includes, for example, the same material.

Note that, in the first embodiment, the second light reflecting film 401 is separated from the reflection attenuating film 312 with an insulating film (no reference character is attached) being interposed therebetween.

In the color conversion region 4, a separation wall 41 is provided at a portion that is between adjacent second light reflecting films 401 and is between the color conversion layers 40 adjacent in the planar direction. The separation wall 41 is configured to separate the color conversion layers 40 from each other, and hold the color conversion layers 40. The separation wall 41 includes, for example, a silicon oxide film or a silicon nitride film.

### (5) Configuration of Filter Region 5

The filter region 5 is provided on the color conversion region 4. The filter region 5 includes a filter 50. The filter 50 is provided on the color conversion layer 40, and blocks a particular emitted-light color emitted from the light emitting element 30 or absorbs the particular emitted-light color. Here, the particular emitted-light color is, for example, blue.

### (6) Configuration of Optical System Region 6

An optical system region 6 is provided on the filter region 5. An on-chip lens 60 is provided in the optical system region 6. The on-chip lens 60 includes a plurality of convex lenses that is integrally formed. The convex lenses are each disposed for corresponding one of the light emitting elements 30. The on-chip lens 60 includes, for example, a resin material or an inorganic material.

### (7) Configuration of Device Arrangement Region 7

As described above, in the device arrangement region 7, a plurality of light emitting elements 30 is arranged in a matrix in the planar direction. The plurality of light emitting elements 30 is formed from the singulated compound semiconductor layer. For example, the light emitting element 30 has a rectangular shape having a dimension of one side being greater than or equal to 0.5 µm and less than or equal to 20 µm, in plan view.

### (8) Configuration of Peripheral Region 8

In the peripheral region 8, the through wiring line 313 is disposed on the device arrangement region 7 side (inner side), and an external terminal 26P is provided on the outer side.

As described above, one end of the through wiring line 313 is electrically coupled to the first compound semiconductor layer 31 of the light emitting element 30 through the transparent electrode 311 and the reflection attenuating film 312. Another end of the through wiring line 313 is electrically coupled to the drive circuit 21 through the joining portion of the first terminal 391 and the first terminal 281.

The external terminal 26P is exposed from an opening extending from the filter region 5 into a portion of the substrate region 2. The external terminal 26P is electrically coupled to the drive circuit 21. The external terminal 26P is configured to allow a wire that is not illustrated in the drawing to be electrically coupled thereto. Through the wire, the external terminal 26P receives a drive signal that is inputted from the outside of the light emitting device 1 to the drive circuit 21. The external terminal 26P includes, for example, the same conductive material as the second light shielding film 26.

### [Method of Manufacturing Light Emitting Device 1]

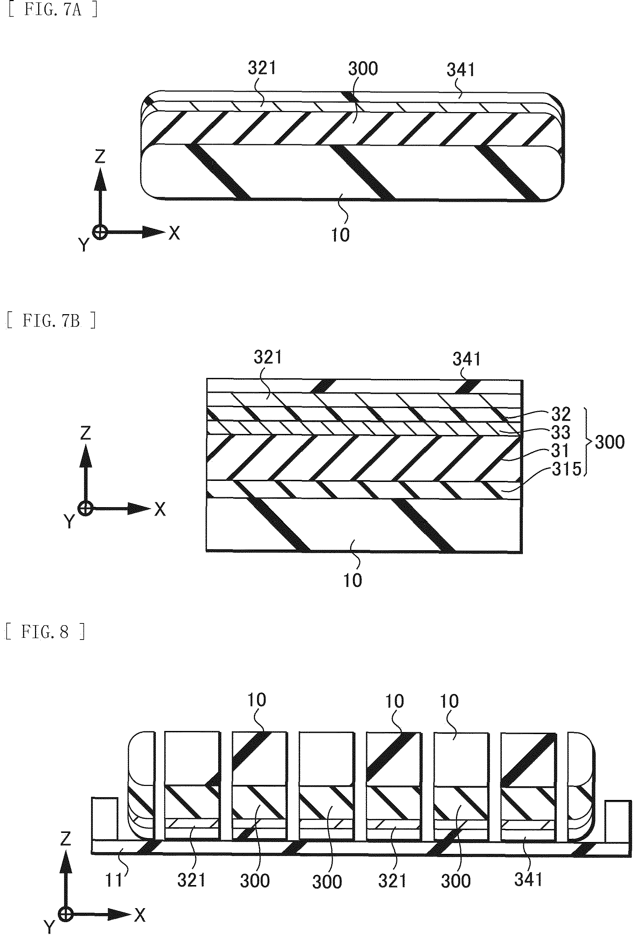

A method of manufacturing the light emitting device 1 according to the first embodiment includes the following manufacturing processes illustrated in FIGs. 7 to 26. Below, the method of manufacturing the light emitting device 1 will be described in detail.

### (1) Method of Manufacturing Light Emitting Body 35 and Light Emitting Body Region 3

First, a compound semiconductor layer 300 is formed on a growth substrate 10 (see FIG. 7A). For the growth substrate 10, a sapphire substrate is used as an epitaxial growth substrate. For the compound semiconductor layer 300, an undoped gallium nitride layer 315, the first compound semiconductor layer (n-GaN) 31, the active layer 33, and the second compound semiconductor layer (p-GaN) are formed sequentially from a surface of the growth substrate 10 (see FIG. 7B).

As illustrated in FIGs. 7A and 7B, the transparent electrode 321 and an insulating film 341 are formed sequentially on the compound semiconductor layer 300.

Thereafter, in a state where the insulating film 341 is opposed to a dicing tape, and the growth substrate 10 is inverted, the growth substrate 10 is adhered to the dicing tape 11 (see FIG. 8). As illustrated in FIG. 8, a dicing process is performed to dice the growth substrate 10, the compound semiconductor layer 300, the transparent electrode 321, and the insulating film 341 into individual singulated pieces. In plan view, the singulated growth substrate 10 has a dimension of one side being greater than or equal to 4 mm and less than or equal to 30 mm.

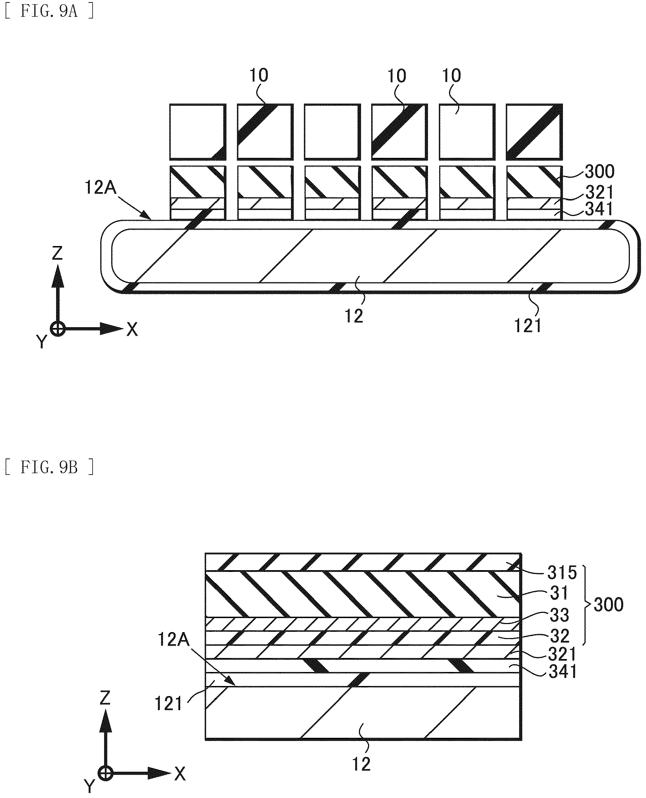

The singulated growth substrate 10, the singulated compound semiconductor layer 300, the singulated transparent electrode 321, and the singulated insulating film 341 are joined to a first joining surface 12A of a first support substrate 12 (see FIGs. 9A and 9B). This joining is performed with the insulating film 341 and the first joining surface 12A of the first support substrate 12 being opposed to each other. For example, a silicon substrate is used for the first support substrate 12, and an insulating film 121 is formed on the first joining surface 12A of the first support substrate 12. The insulating film 121 includes, for example, a silicon nitride film.

As illustrated in FIGs. 9A and 9B, the growth substrate 10 is peeled off.

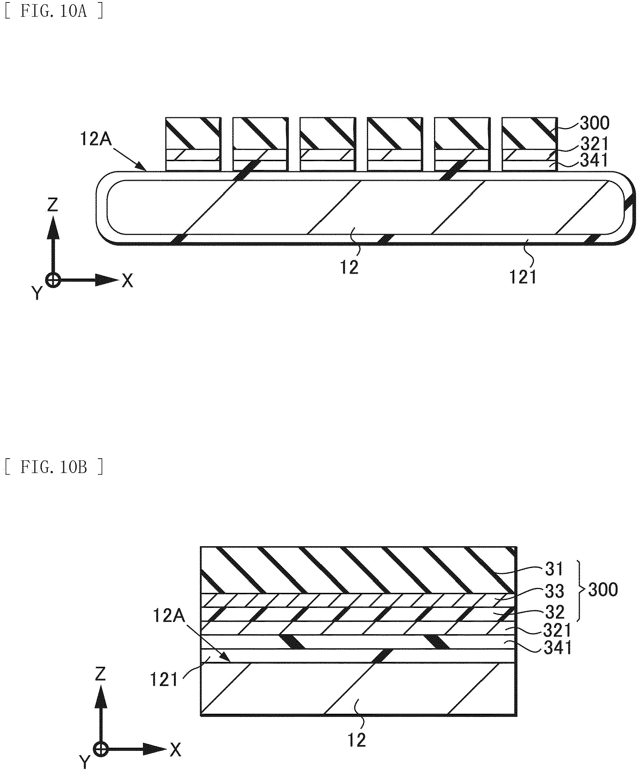

Thereafter, as illustrated in FIGs. 10A and 10B, the undoped gallium nitride layer 315 of the compound semiconductor layer 300 is removed. The undoped gallium nitride layer 315 is removed, for example, through a polishing process.

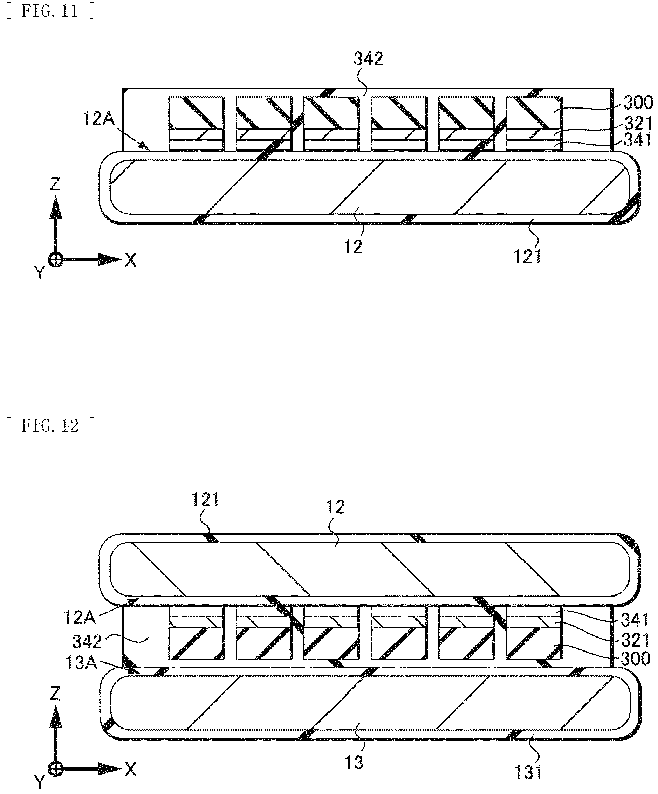

As illustrated in FIG. 11, the insulating film 342 in which the plurality of singulated compound semiconductor layers 300 is embedded is formed on the first support substrate 12. The insulating film 342 includes, for example, a silicon oxide film. After this silicon oxide film is formed, a planarizing process is performed on the surface of this silicon oxide film. The planarizing process used includes, for example, a chemical mechanical polishing (CMP) process.

A second support substrate 13 is prepared. As illustrated in FIG. 12, the first joining surface 12A of the first support substrate 12 is opposed to a second joining surface 13A of the second support substrate 13 to join the first support substrate 12 to the second joining surface 13A. Through this joining, the directions of upward and downward of the compound semiconductor layer 300 is inverted. That is, the second compound semiconductor layer 32 is disposed at the upper layer of the compound semiconductor layer 300, and the first compound semiconductor layer 31 is disposed at the lower layer. For example, a plasma joining process is used for joining them. An insulating film 131 is formed in advance on the second joining surface 13A of the second support substrate 13. The insulating film 131 includes, for example, a silicon nitride film.

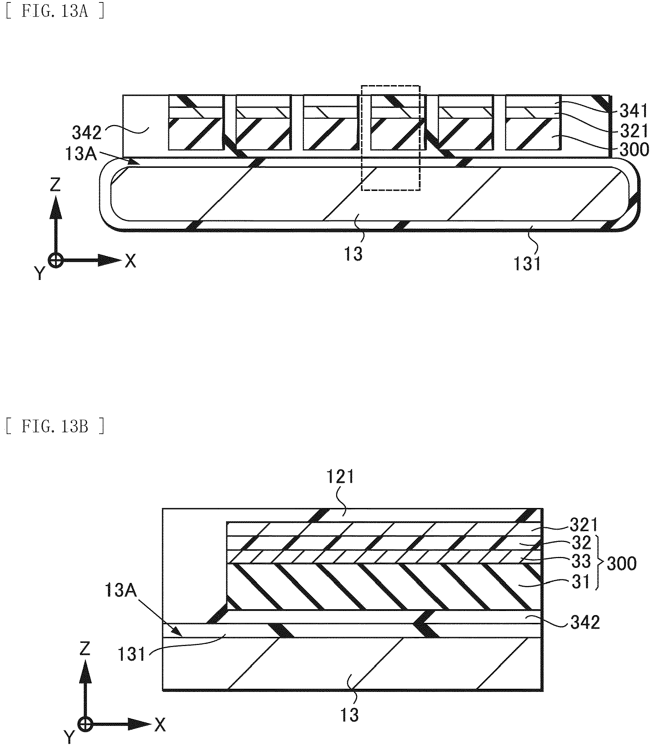

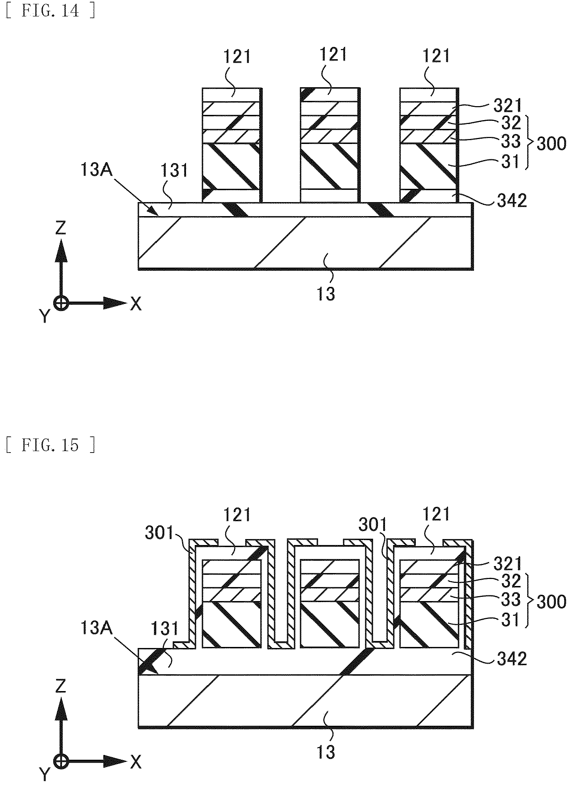

As illustrated in FIGs. 13A and 13B, the first support substrate 12 is peeled off. Here, FIG. 13B is an enlarged cross-sectional view of a region surrounded by a dashed line in FIG. 13A. Note that enlarged cross-sectional views illustrated in FIG. 14 and thereafter correspond to the enlarged cross-sectional view illustrated in FIG. 13B.

As illustrated in FIG. 14, the singulated compound semiconductor layer 300 is separated into individual pieces to form the plurality of light emitting elements 30. In a case where one light emitting element 30 is formed as one pixel, this process is a process of separating pixels from each other. Separating the compound semiconductor layer 300 is performed, for example, by a dry etching process.

Here, typically, the thickness of the second compound semiconductor layer 32 is thinner, by approximately one digit, than the thickness of the first compound semiconductor layer 31. Thus, by separating the compound semiconductor layer 300 from the second compound semiconductor layer 32 side, the accuracy of processing the active layer 33 is improved.

As illustrated in FIG. 15, the first light reflecting film 301 is formed along side surfaces of the light emitting element 30 and the surface of the second compound semiconductor layer 32. The first light reflecting film 301 is formed on the surface of the second compound semiconductor layer 32, except for a portion coupled to the plug wiring line 36. Note that, actually, the first light reflecting film 301 is formed on the surface of the insulating film 121.

As described above, the first light reflecting film 301 is formed to have a constant film thickness using a chemical vapor deposition method or an atomic layer deposition method.

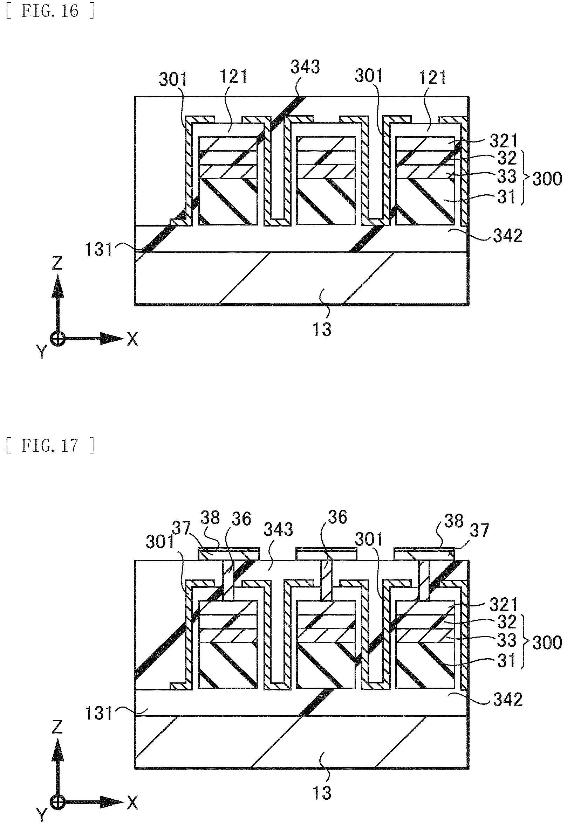

As illustrated in FIG. 16, an insulating film 343 is formed around the light emitting element 30 including the first light reflecting film 301, and the light emitting element 30 is embedded in the insulating film 343. The surface of the insulating film 343 is planarized, for example, by a chemical machine polishing process. The insulating film 343 includes, for example, a silicon oxide film.

A contact hole (no reference character is attached) extending from the surface of the insulating film 343 and reaching the surface of the second compound semiconductor layer 32 of the light emitting element 30 is formed in the insulating film 343, and the plug wiring line 36 is formed in this contact hole (see FIG. 17). As for the plug wiring line 36, after the contact hole is first formed in the insulating film 343, a metal film for the plug wiring line 36 is formed in the contact hole and on the insulating film 343. The metal film is formed, for example, by using a chemical vapor deposition method that provides favorable step coverage. In addition, as the metal film on the insulating film 343 is removed, for example, by a chemical mechanical polishing process, the metal film is left in the contact hole, and this metal film is formed as the plug wiring line 36.

Thereafter, the first light absorbing film 37 and the first light shielding film 38 are formed sequentially on the plug wiring line 36 and the insulating film 343 (see FIG. 17). After the first light absorbing film 37 and the first light shielding film 38 are formed, an etching process is performed on them using a mask to process them into a predetermined shape.

As illustrated in FIG. 17, an insulating film 344 in which the first light absorbing film 37 and the first light shielding film 38 are embedded is formed, and the surface of the insulating film 344 is planarized. The insulating film 344 includes, for example, a silicon oxide film.

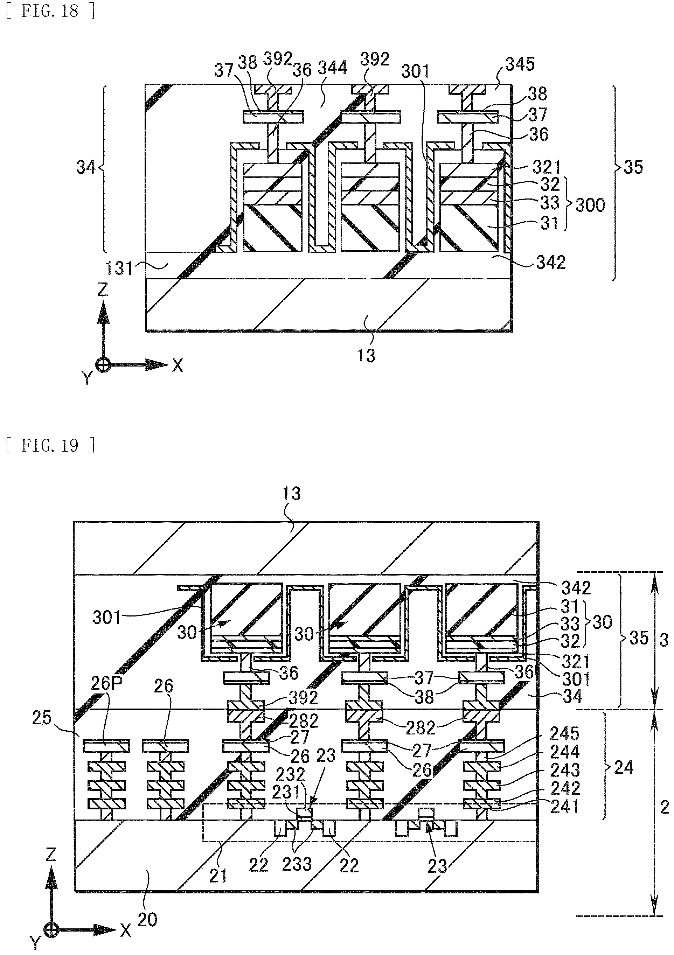

As illustrated in FIG. 18, in the peripheral region 8, the first terminal 391 is formed on the insulating film 344, and through the same manufacturing process, the second terminal 392 is formed in the device arrangement region 7. The first terminal 391 and the second terminal 392 each have an exposed surface, and the periphery of each of the first terminal 391 and the second terminal 392 is embedded in the insulating film 345. The surface of the first terminal 391, the surface of the second terminal 392, and the surface of the insulating film 345 are planarized by a chemical machine polishing process.

Here, the insulating film 341 to insulating film 345 constitute one insulating body 34, and the plurality of arranged light emitting elements 30 and the insulating body 34 formed around the light emitting elements 30 constitute the light emitting body 35 (see FIG. 1). Once the light emitting body 35 is formed, the light emitting body region 3 illustrated in FIG. 1 is substantially completed except for the transparent electrode 311 and the reflection attenuating film 312.

### (2) Method of Joining Light Emitting Body Region 3 and Substrate Region 2

As illustrated in FIG. 19, the light emitting body region 3 is mounted on the substrate region 2 with the substrate 20 and the second support substrate 13 being opposed to each other, and the substrate region 2 and the light emitting body region 3 are joined together.

The drive circuit 21 is mounted at the main surface portion of the substrate 20 of the substrate region 2. Furthermore, in the substrate region 2, the wiring layer 24, the second light shielding film 26, the second light absorbing film 27, the first terminal 281, and the second terminal 282 are formed on the substrate 20. Joining is performed in a state where the first terminal 391 of the light emitting body region 3 is electrically coupled to the first terminal 281 of the substrate region 2 and the second terminal 392 of the light emitting body region 3 is electrically coupled to the second terminal 282 of the substrate region 2.

### (3) Method of Manufacturing Transparent Electrode 311 and Reflection Attenuating Film 312

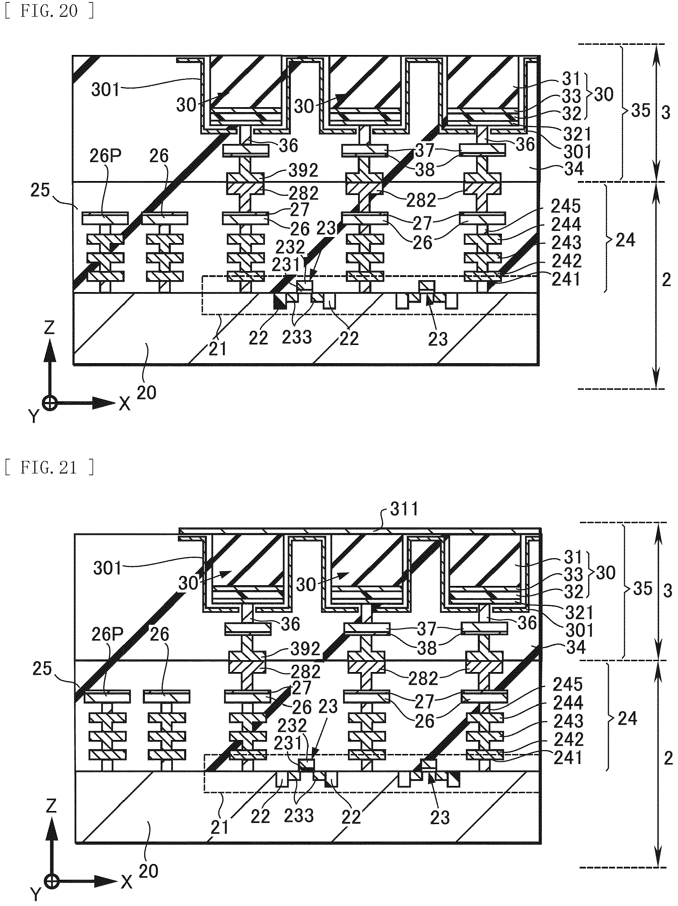

The second support substrate 13 is removed (see FIG. 20). Removing the second support substrate 13 is performed, for example, by a grinder process or a wet etching process.

Thereafter, as illustrated in FIG. 20, in the light emitting body region 3, the insulating film 342 of the insulating body 34 is removed, and the surface of the first compound semiconductor layer 31 of the light emitting element 30 is exposed. Removing the insulating film 342 is performed by a dry etching process or a wet etching process.

As illustrated in FIG. 21, the transparent electrode 311 is formed on the first compound semiconductor layers 31 of the plurality of light emitting elements 30. For the transparent electrode 311, a film including indium tin oxide is formed, for example, using sputtering or a vapor deposition method, and after the formation of the film, the film is processed into a predetermined shape by a wet etching process.

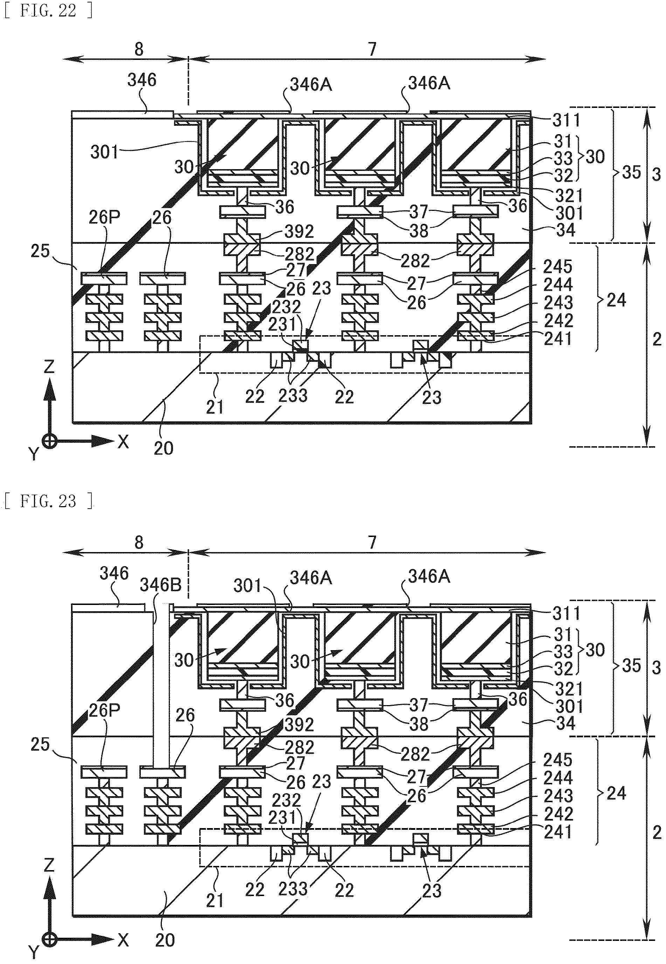

The insulating film 346 is formed on the transparent electrode 311 (see FIG. 22). The insulating film 346 includes, for example, a silicon oxide film.

As illustrated in FIG. 22, an opening 346A is formed in the insulating film 346 between light emitting elements 30 in the device arrangement region 7. The opening 346A is formed, for example, by an etching process.

As illustrated in FIG. 23, an opening 346B extending from the surface of the insulating film 346 to the inside of the insulating body 34 is formed at a position, in the peripheral region 8, that corresponds to the first terminal 391. The surface of the first light absorbing film 37 on the first terminal 391 is exposed in the opening 346B.

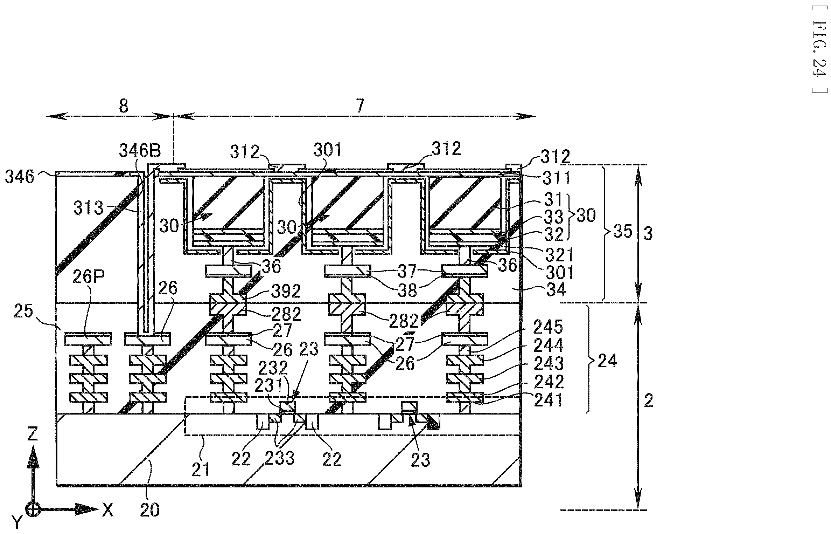

As illustrated in FIG. 24, the reflection attenuating film 312 is formed on the insulating film 346 between light emitting elements 30. The reflection attenuating film 312 is electrically coupled to the transparent electrode 311 through the inside of the opening 346A.

In addition, through the same manufacturing process, the through wiring line 313 is formed within the opening 346B in the peripheral region 8. In the manufacturing method described here, the through wiring line 313 is electrically coupled to the second light shielding film 26 (corresponding to a first terminal according to the present disclosure) exposed in the opening 346B.

The reflection attenuating film 312 and the through wiring line 313 are formed, for example, by a sputtering method, and is processed into a predetermined shape by a dry etching process.

Through the manufacturing processes up to this point, the light emitting body region 3 joined to the substrate region 2 is completed.

### (4) Method of Manufacturing Color Conversion Region 4, Filter Region 5, and Optical System Region 6

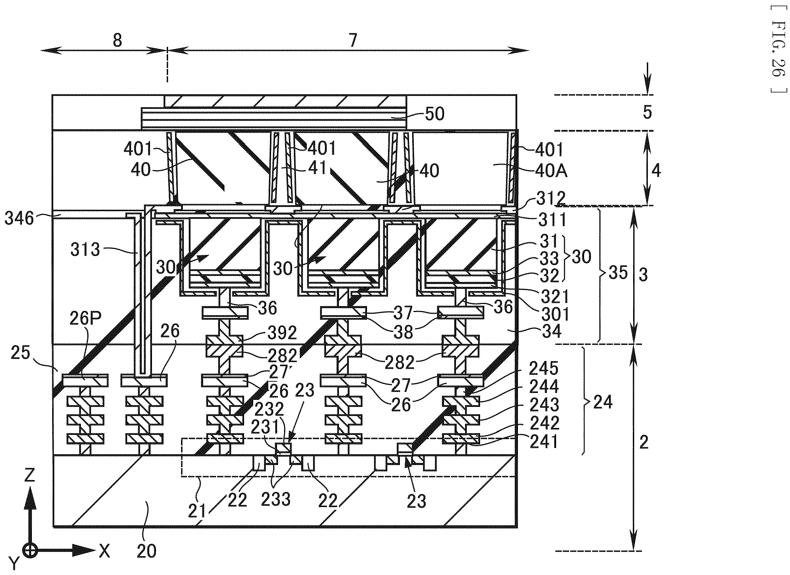

The separation wall 41 is formed between the light emitting elements 30 in the light emitting body region 3 (FIG. 26). The separation wall 41 is formed by forming an insulating film on the entire region of the light emitting body region 3 that includes the device arrangement region 7 and the peripheral region 8 and removing the insulating film on the light emitting elements 30. The insulating film includes, for example, a silicon oxide film, and removing the insulating film is performed by a dry etching process.

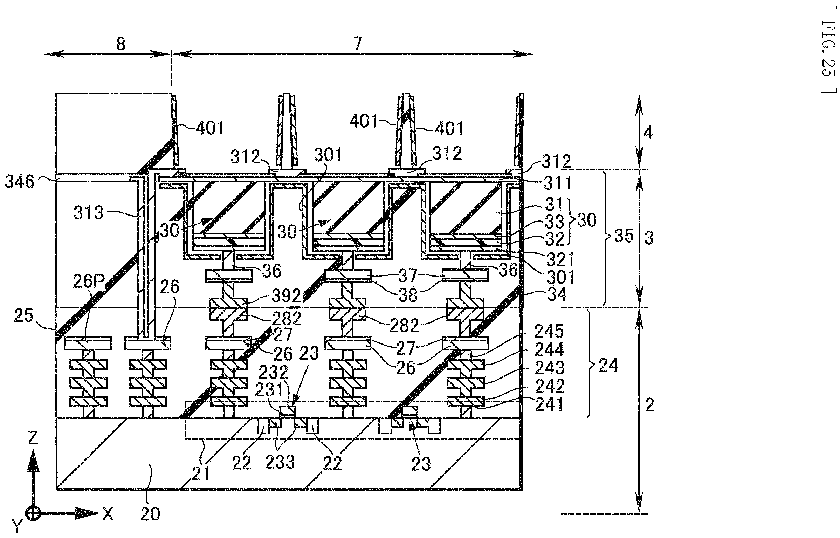

As illustrated in FIG. 25, the second light reflecting film 401 is formed on side surfaces of the separation wall 41. The second light reflecting film 401 is formed by a chemical vapor deposition method or an atomic layer deposition method that provides favorable step coverage. The second light reflecting film 401 formed on the light emitting element 30 and the separation wall 41 are removed by an etch back process.

Thereafter, the color conversion layer 40 is formed on the light emitting element 30 in a region of which side surfaces are surrounded by the separation wall 41. The color conversion layer 40 includes a resin material (see FIG. 26). In addition, a transparent resin layer 40A is formed on the light emitting element 30 serving as a sub-pixel.

Once the color conversion layer 40 is formed, the color conversion region 4 is completed.

Note that, in a case where the light emitting device 1 is configured as a single-color light emitting device, the color conversion region 4 is not provided.

As illustrated in FIG. 26, the filter 50 is formed on the color conversion layer 40. The filter 50 blocks or absorbs a particular emitted-light color. Once the filter 50 is formed, the filter region 5 is completed.

The on-chip lens 60 is formed on the filter region 5 (see FIG. 1). Once the on-chip lens 60 is formed, the optical system region 6 is completed.

As illustrated in FIG. 1 that has been described above, an opening 15 extending from the optical system region 6 and reaching the external terminal 26P of the substrate region 2 is formed in the peripheral region 8. The surface of the external terminal 26P is exposed in the opening 15.

Once the series of these manufacturing processes ends, the method of manufacturing the light emitting device 1 according to the first embodiment ends, and the light emitting device 1 is completed.

### [Workings and Effects]

(1) The light emitting device 1 according to the first embodiment includes the light emitting body 35 as illustrated in FIGs. 1 and 2. In the light emitting body 35, the plurality of light emitting elements 30 is arranged along the direction of the light emitting surface, and the insulating body 34 is formed around the plurality of plurality of light emitting elements 30 except for the light emitting surface. The plurality of light emitting elements 30 is formed from the singulated compound semiconductor layer 300 (see FIG. 8). This makes it possible to increase the size of the substrate 20 at which the drive circuit 21 is mounted, regardless of the size of the growth substrate 10 (see FIGs. 7A and 7B) from which the light emitting elements 30 are manufactured.

For example, by forming the light emitting body 35 such that the plurality of light emitting elements 30 manufactured from a plurality of growth substrates 10 are arranged, it is possible to join the light emitting body 35 to the substrate 20 having a size larger than that of the growth substrate 10, thereby forming the light emitting device 1 having a size as large as the size of the substrate 20.

Thus, it is possible to provide the light emitting device 1 that makes it possible to achieve an increased size.

(2) In addition, in the light emitting device 1, as illustrated in FIGs. 1 and 2, the light emitting element 30 includes the light-emitting diode including the first compound semiconductor layer 31, the second compound semiconductor layer 32, and the active layer 33. This makes it possible to achieve the increased size of the light emitting device 1 using the light-emitting diode as the light emitting element 30.

(3) In addition, the light emitting device 1 includes the first light reflecting film 301 as illustrated in FIGs. 1 and 2. The first light reflecting film 301 is provided along the side surface of the first compound semiconductor layer 31, the side surface of the active layer 33, the side surface of the second compound semiconductor layer 32, and the surface, on the substrate 20 side, of the second compound semiconductor layer 32. This makes it possible to reflect the light emitted from the light emitting element 30 to guide it toward the light emitting surface, which makes it possible to improve the light extraction efficiency.

In addition, the first light reflecting film 301 has the constant film thickness. By reducing the film thickness of the first light reflecting film 301 provided along the surface, on the substrate 20 side, of the second compound semiconductor layer 32, the film thickness of the first light reflecting film 301 is reduced. The first light reflecting film 301 is provided along each of the side surfaces of the first compound semiconductor layer 31, the side surfaces of the active layer 33, and the side surfaces of the second compound semiconductor layer 32. Thus, it is possible to dispose the first light reflecting film 301 around the side surfaces of the light emitting element 30 even if the spacing between adjacent light emitting elements 30 is reduced, which makes it possible to improve the light extraction efficiency.

(4) In addition, in the light emitting device 1, as illustrated in FIGs. 1, 2, and 12, the first light reflecting film 301 includes a metal film or a metallic compound film that is formed by a chemical vapor deposition method or an atomic layer deposition method. Thus, the first light reflecting film 301 exhibits favorable step coverage, which makes it possible to reduce the film thickness of the first light reflecting film 301 provided along each of the side surfaces of the first compound semiconductor layer 31, the side surfaces of the active layer 33, and the side surfaces of the second compound semiconductor layer 32. This makes it possible to dispose the first light reflecting film 301 around the side surfaces of the light emitting element 30 even if the spacing between adjacent light emitting elements 30 is reduced, which makes it possible to improve the light extraction efficiency.

(5) Furthermore, the light emitting device 1 further includes the transparent electrode 311 and the reflection attenuating film 312, as illustrated in FIGs. 1 to 5. The transparent electrode 311 is disposed at the light emitting surface of the plurality of light emitting elements 30 and is provided integrally for the plurality of light emitting elements 30. The reflection attenuating film 312 is disposed on and overlaps with at least the transparent electrode 311 between the plurality of light emitting elements 30. The reflection attenuating film 312 has a reflectance at an interface between the reflection attenuating film 312 and the transparent electrode 311 that is lower than a reflectance of the transparent electrode 311 at an interface between the transparent electrode 311 and an insulating material.

Thus, as illustrated in FIG. 3, leakage light LL emitted from the light emitting element 30 is attenuated at the time of being reflected at the interface between the transparent electrode 311 and the reflection attenuating film 312, in a process in which the leakage light LL is transmitted through the inside of the transparent electrode 311 to other adjacent light emitting elements 30. This makes it possible to attenuate leakage light between adjacent light emitting elements 30.

(6) In addition, in the light emitting device 1, as illustrated in FIG. 1 to 3, and 5, the reflection attenuating film 312 has electrical conductivity, and is electrically coupled to the transparent electrode 311. That is, the reflection attenuating film 312 is provided as a wiring line that reduces a resistance value of the transparent electrode 311. As the resistance value of the transparent electrode 311 is allowed to be reduced, it is possible to reduce the film thickness of the transparent electrode 311. This reduces the cross sectional area of a path of leakage light of the transparent electrode 311, which makes it possible to further reduce the leakage light between the light emitting elements 30.

(7) Furthermore, in the light emitting device 1, as illustrated in FIGs. 1, 2, and 5, the reflection attenuating film 312 extends to the peripheral region 8 of the light emitting body 35. In the peripheral region 8, the reflection attenuating film 312 is electrically coupled to the first terminal 391 or the first terminal 281 through the through wiring line 313. The through wiring line 313 penetrates the insulating body 34 and includes a conductive material same as that of the reflection attenuating film 312. Alternatively, as illustrated in FIG. 24, the through wiring line 313 is electrically coupled to the second light shielding film 26 used as the first terminal.

In other words, it is possible to form the reflection attenuating film 312 including the same conductive material (or using the same manufacturing processes) as the through wiring line 313 by using the through wiring line 313 formed in the peripheral region 8. This makes it possible to easily provide the reflection attenuating film 312.

(8) In addition, in the light emitting device 1, the reflection attenuating film 312 illustrated in FIGs. 1 to 3 and 5 includes a single layer film or a combined film that includes one or more materials selected from tungsten, aluminum, titanium, tantalum, copper, and titanium nitride. That is, the reflection attenuating film 312 includes an existing material having high stability and high reliability, which makes it possible to easily form the reflection attenuating film 312.

(9) Furthermore, the light emitting device 1 includes the color conversion layer 40 and the second light reflecting film 401 as illustrated in FIG. 1. The color conversion layer 40 is disposed on the light emitting surface for each of the plurality of light emitting elements 30. The second light reflecting film 401 is disposed around a side surface of the color conversion layer 40, and reflects light emitted from the plurality of light emitting elements 30 and light scattered by the color conversion layer 40.

This makes it possible to achieve a color light emitting device having high light extraction efficiency.

(10) In addition, in the light emitting device 1, as illustrated in FIG. 1, the on-chip lens 60 is provided as an optical lens on the color conversion layer 40. Providing the on-chip lens 60 makes it possible to improve a property of collecting extracted light.

(11) Furthermore, the light emitting device 1 includes the plug wiring line 36 as illustrated in FIGs. 1 and 2. One end surface of the plug wiring line 36 in an extending direction penetrates the first light reflecting film 301 in a thickness direction and is electrically coupled to the surface, on the substrate 20 side, of the second compound semiconductor layer 32 of the plurality of light emitting elements 30. Another end surface of the plug wiring line 36 in the extending direction is electrically coupled to the second terminal 392 or the second terminal 282. It is possible to couple the plug wiring line 36 to the second compound semiconductor layer 32 at the dimension that is the same as the opening dimension of the contact hole formed in the insulating film 343 illustrated in FIG. 17. That is, the area where the plug wiring line 36 and the second compound semiconductor layer 32 are coupled to each other is reduced. It is sufficient that the plug wiring line 36 and the first light reflecting film 301 are electrically separated from each other. Thus, the spacing between the plug wiring line 36 and the first light reflecting film 301 is reduced. This makes it possible to reduce leakage light emitted from the light emitting element 30 toward the substrate 20 side.

(12) In addition, the light emitting device 1 includes the first light absorbing film 37 as illustrated in FIGs. 1 and 2. The first light absorbing film 37 is provided at the outer periphery between the first light reflecting film 301 and the second terminal 392 or the second terminal 282. The outer periphery intersects with the extending direction of the plug wiring line 36. The first light absorbing film 37 absorbs leakage light from between the first light reflecting film 301 and the plug wiring line 36 toward the substrate 20 side. This makes it possible to reduce the leakage light emitted from the light emitting element 30 toward the substrate 20 side.

(13) Furthermore, in the light emitting device 1, the first light absorbing film 37 illustrated in FIGs. 1 and 2 includes titanium nitride, cobalt, nitrogen-doped titanium oxide, tantalum nitride, or amorphous carbon. As the first light absorbing film 37 includes a material having high light absorptance, it is possible to further reduce the leakage light emitted from the light emitting element 30 toward the substrate 20 side.

(14) In addition, the light emitting device 1 includes the first light shielding film 38 as illustrated in FIGs. 1 and 2. The first light shielding film 38 is provided at the outer periphery between the first light reflecting film 301 and the second terminal 392 or the second terminal 282. The outer periphery intersects with the extending direction of the plug wiring line 36. The first light shielding film 38 blocks leakage light from between the first light reflecting film 301 and the plug wiring line 36 toward the substrate 20 side. This makes it possible to reduce the leakage light emitted from the light emitting element 30 toward the substrate 20 side.

(15) Furthermore, in the light emitting device 1, the first light shielding film 38 illustrated in FIGs. 1 and 2 is provided to include aluminum, copper, tungsten, or titanium. Because the first light shielding film 38 includes a material having a high light reflectance, it is possible to further reduce the leakage light emitted from the light emitting element 30 toward the substrate 20 side.

(16) In addition, in the light emitting device 1, the drive circuit 21 includes the insulated gate field effect transistor 23 serving as the driving transistor, as illustrated in FIG. 1. Furthermore, in the substrate region 2, the light emitting device 1 includes the second light shielding film 26 and the second light absorbing film 27 on the side of the plurality of light emitting elements 30 with respect to the insulated gate field effect transistor 23. The second light shielding film 26 blocks leakage light from the plurality of light emitting elements 30 toward the substrate 20 side. The second light absorbing film 27 absorbs the leakage light from the plurality of light emitting elements 30 toward the substrate 20 side.

This makes it possible to further reduce the leakage light emitted from the light emitting elements 30 toward the substrate 20 side.

(17) In addition, in the light emitting device 1, the second light shielding film 26 illustrated in FIG. 1 is provided to include aluminum, copper, tungsten, or titanium. As the second light shielding film 26 includes a material having a high light reflectance, it is possible to further reduce the leakage light emitted from the light emitting element 30 toward the substrate 20 side.

(18) Furthermore, in the method of manufacturing the light emitting device 1, first, the compound semiconductor layer 300 is formed as illustrated in FIGs. 7A and 7B. The compound semiconductor layer 300 is obtained by causing the first compound semiconductor layer 31, the active layer 33, and the second compound semiconductor layer 32 to sequentially grow on the growth substrate 10. As illustrated in FIG. 8, the singulated compound semiconductor layer 300 is formed by dicing the growth substrate 10 and the compound semiconductor layer 300. The second compound semiconductor layer 32 is caused to be opposed to the first joining surface 12A of the first support substrate 12, and the compound semiconductor layer 300 is joined to the first joining surface 12A (see FIGs. 9A and 9B). As illustrated in FIGs. 9A and 9B, the growth substrate 10 is peeled off. As illustrated in FIG. 12, the first compound semiconductor layer 31 is caused to be opposed to the second joining surface 13Aof the second support substrate 13, and the compound semiconductor layer 300 is joined to the second joining surface 13A. As illustrated in FIGs. 13A and 13B, the first support substrate 12 is removed. As illustrated in FIG. 14, the plurality of light emitting elements 30 is formed from the singulated compound semiconductor layer 300. As illustrated in FIG. 18, the light emitting body 35 is formed by forming the insulating body 34 around the plurality of light emitting elements 30 on the second support substrate 13. As illustrated in FIG. 19, the second support substrate is joined to the substrate 20 on which the drive circuit 21, to which the second light shielding film 26 as the first terminal (or the first terminal 281) and the second terminal 282 are coupled, is mounted, in a state where the light emitting body 35 is interposed between the substrate 20 and the second support substrate and the second compound semiconductor layer 32 is electrically coupled to the second terminal 282. As illustrated in FIG. 20, the second support substrate 13 is removed. As illustrated in FIG. 24, the first compound semiconductor layer 31 and the second light shielding film 26 are electrically coupled to each other.

In such a method of manufacturing the light emitting device 1, the plurality of light emitting elements 30 is formed from the singulated compound semiconductor layer 300 (see FIG. 8), and the insulating body 34 is formed around the plurality of light emitting elements 30 to form the light emitting body 35. In addition, as the light emitting body 35 is joined to the substrate 20, it is possible to increase the size of the substrate 20 at which the drive circuit 21 is mounted, regardless of the size of the growth substrate 10 (see FIGs. 7A and 7B) from which the light emitting elements 30 are manufactured.

As one example, the light emitting elements 30 manufactured from the growth substrate 10 having a size of 4 inches to 6 inches are mounted on the substrate 20 having, for example, a size of 8 inches to 12 inches. This makes it possible to manufacture the light emitting device 1 having a size as large as the size of the substrate 20.

In addition, it is possible to select a non-defective light emitting element 30 to form the light emitting body 35, thereby mounting this light emitting body 35 on the substrate 20. This makes it possible to improve yield in manufacturing the light emitting device 1.

Moreover, the singulated compound semiconductor layer 300 is processed in a state of being joined to the second support substrate 13, to form the light emitting elements 30. The second support substrate 13 is joined to the substrate 20, and the light emitting element 30 is mounted on the substrate 20. Because the second support substrate 13 and the substrate 20 are each in a state of being a wafer, wafers are joined to each other. This makes it possible to improve accuracy of alignment at the time of joining.

(19) Furthermore, in the method of manufacturing the light emitting device 1, as illustrated in FIG. 20, the transparent electrode 311 is formed at the light emitting surface of the plurality of light emitting elements 30 after the second support substrate 13 is removed. As illustrated in FIG. 24, the reflection attenuating film 312 is formed on the transparent electrode 311 between the plurality of light emitting elements 30 in the same process as the process of coupling the first compound semiconductor layer 31 and the first terminal 391 to each other. The reflection attenuating film 312 has a reflectance at an interface between the reflection attenuating film 312 and the transparent electrode 311 that is lower than a reflectance of the transparent electrode 311 at an interface between the transparent electrode 311 and an insulating material.

Thus, the reflection attenuating film 312 is formed in the same process as the process of coupling the first compound semiconductor layer 31 and the first terminal 391 to each other, specifically, as the manufacturing process of forming the through wiring line 313. This makes it possible to reduce the number of manufacturing processes, as compared with a case where the reflection attenuating film 312 is formed through a different manufacturing process.

### <Second Embodiment>

### [Configuration of Light Emitting Device 1]

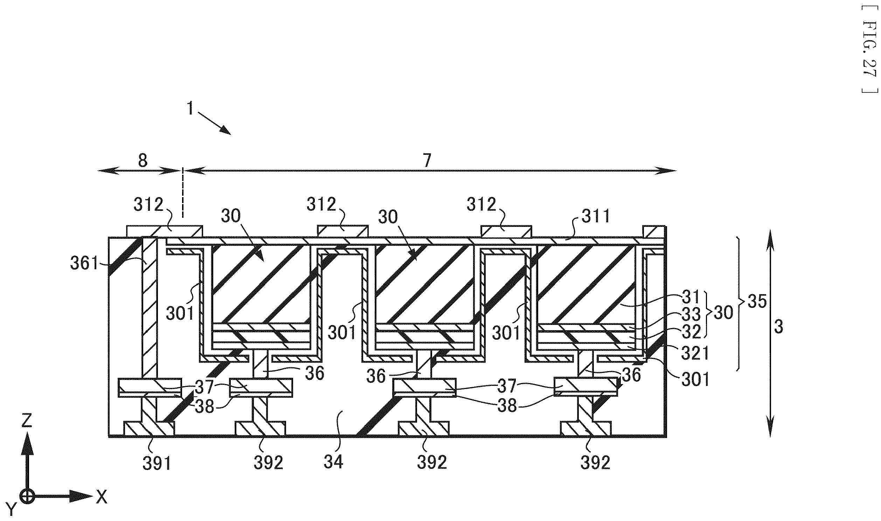

The light emitting device 1 according to the second embodiment of the present technology includes a through wiring line 361 that couples the first compound semiconductor layer 31 of the light emitting element 30 and the first terminal 391 to each other, as illustrated in FIG. 27. The upper end of the through wiring line 361 is electrically coupled to the reflection attenuating film 312 extending from the device arrangement region 7 to the peripheral region 8.

The through wiring line 361 includes the same electrically conductive material as the plug wiring line 36 that electrically couples the second compound semiconductor layer 32 and the second terminal 392 to each other. In addition, the through wiring line 361 is formed through a manufacturing process that is the same as the process of manufacturing the plug wiring line 36.

### [Workings and Effects]

The light emitting device 1 according to the second embodiment makes it possible to achieve workings and effects similar to the workings and effects achievable by the light emitting device 1 according to the first embodiment.

In addition, the light emitting device 1 includes the through wiring line 361 as illustrated in FIG. 27. Because the through wiring line 361 includes the same electrically conductive material as the plug wiring line 36, it is possible to easily achieve the structure of coupling the first compound semiconductor layer 31 of the light emitting element 30 and the first terminal 391 to each other.

### <Third Embodiment>

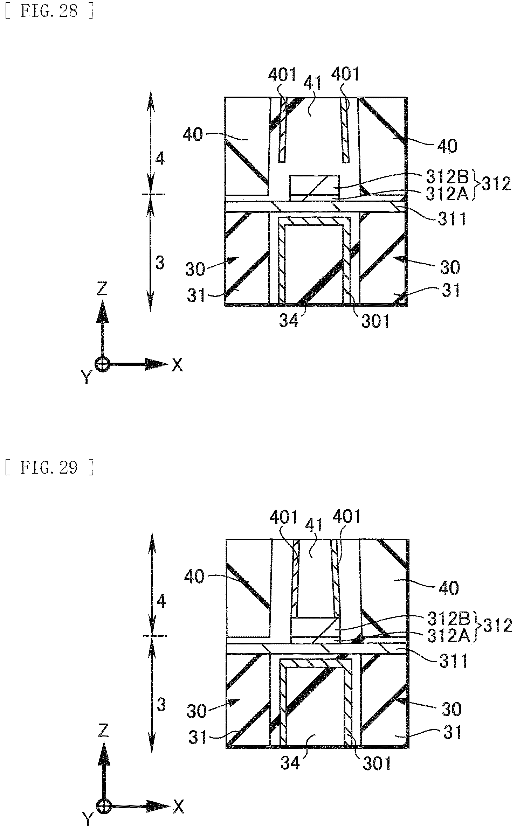

The light emitting device 1 according to the third embodiment of the present technology includes the reflection attenuating film 312 on the transparent electrode 311 between the light emitting elements 30 as illustrated in FIG. 28. Unlike the reflection attenuating film 312 according to the first embodiment illustrated in FIG. 2, the entire lower surface of the reflection attenuating film 312 is joined to the transparent electrode 311 without the insulating film 346 being interposed therebetween.

As compared with the reflection attenuating film 312 according to the first embodiment, the reflection attenuating film 312 according to the third embodiment makes it possible to increase the area in which the transparent electrode 311 is joined. This makes it possible to further reduce the resistance value of the transparent electrode 311, and also makes it possible to reduce the film thickness of the transparent electrode 311.

### <Fourth Embodiment>

The light emitting device 1 according to the fourth embodiment of the present technology includes the reflection attenuating film 312 on the transparent electrode 311 between the light emitting elements 30 as illustrated in FIG. 29. The light emitting device 1 according to the fourth embodiment is a modification example of the light emitting device 1 according to the third embodiment, and the reflection attenuating film 312 is coupled to the second light reflecting film 401 of the color conversion region 4.

In the light emitting device 1 according to the fourth embodiment, the second light reflecting film 401 is coupled to the transparent electrode 311 with the reflection attenuating film 312 being interposed therebetween. Thus, the second light reflecting film 401 and the transparent electrode 311 are kept at the same electric potential.

### <Fifth Embodiment>

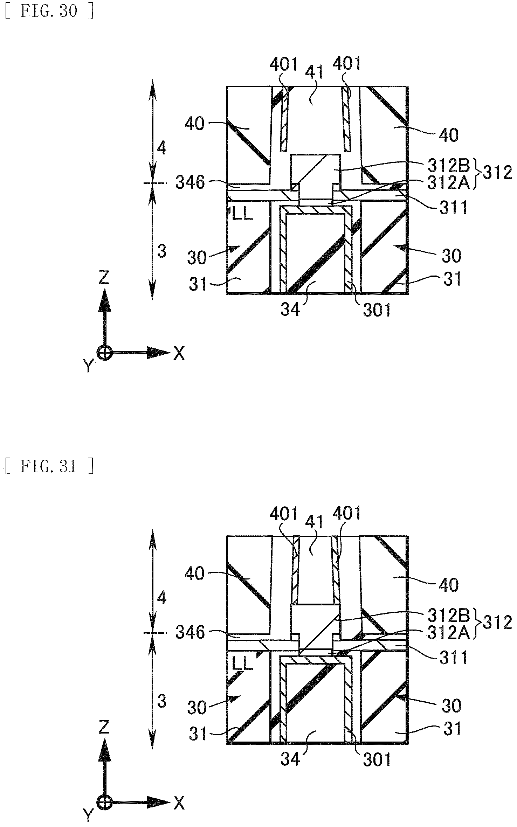

The light emitting device 1 according to the fifth embodiment of the present technology includes the reflection attenuating film 312 on the transparent electrode 311 between the light emitting elements 30 as illustrated in FIG. 30. The light emitting device 1 according to the fifth embodiment is a modification example of the light emitting device 1 according to the third embodiment, and the reflection attenuating film 312 penetrates through the transparent electrode 311, and is coupled to the first light reflecting film 301 provided around the light emitting element 30.

In the light emitting device 1 according to the fifth embodiment, the first light reflecting film 301 is coupled to the transparent electrode 311 with the reflection attenuating film 312 being interposed therebetween. Thus, the first light reflecting film 301 and the transparent electrode 311 are kept at the same electric potential.

Furthermore, in the light emitting device 1, a portion of the reflection attenuating film 312 is formed to penetrate through the transparent electrode 311 in the thickness direction as illustrated in FIG. 30. Thus, the leakage light transmitted to the inside of the transparent electrode 311 is blocked by a portion of the reflection attenuating film 312. This makes it possible to further reduce the leakage light.

### <Sixth Embodiment>

The light emitting device 1 according to the sixth embodiment of the present technology includes the reflection attenuating film 312 on the transparent electrode 311 between the light emitting elements 30 as illustrated in FIG. 31. The light emitting device 1 according to the sixth embodiment is a modification example combining the light emitting device 1 according to the fourth embodiment and the light emitting device 1 according to the fifth embodiment. That is, the reflection attenuating film 312 penetrates through the transparent electrode 311 to be coupled to the first light reflecting film 301 disposed around the light emitting elements 30, and is also coupled to the second light reflecting film 401 of the color conversion region 4.

In the light emitting device 1 according to the sixth embodiment, the first light reflecting film 301 and the second light reflecting film 401 are coupled to the transparent electrode 311 with the reflection attenuating film 312 being interposed therebetween. Thus, the first light reflecting film 301 and the second light reflecting film 401 are each kept at the same electric potential as the transparent electrode 311.

### <Seventh Embodiment>

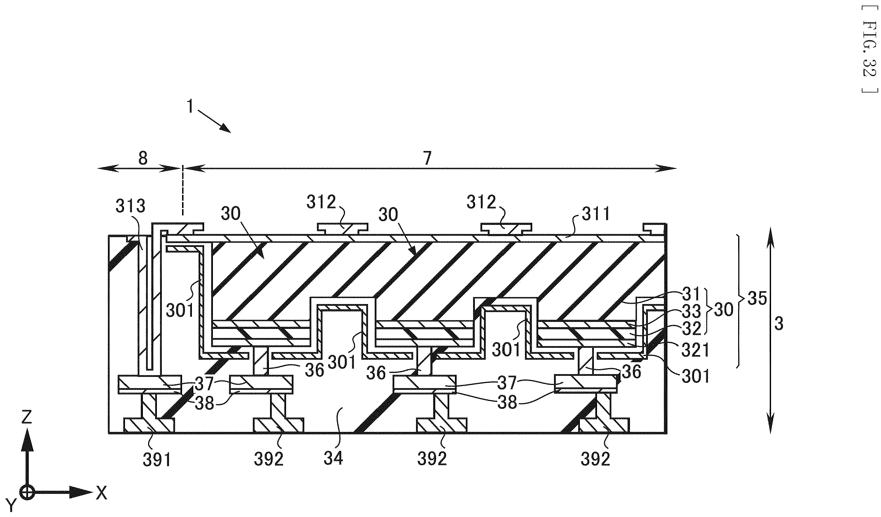

In the light emitting device 1 according to the seventh embodiment of the present technology, the light emitting elements 30 formed from the singulated compound semiconductor layer 300 (see FIG. 8) is not separated for each pixel, as illustrated in FIG. 32. A portion between adjacent light emitting elements 30 is cut from the second compound semiconductor layer 32 beyond the active layer 33 up to some middle point of the first compound semiconductor layer 31, and is separated. The first compound semiconductor layers 31 adjacent to each other are coupled to each other.

In order to suppress color mixture (crosstalk) between the adjacent light emitting elements 30, it is preferable that the adjacent light emitting elements 30 be separated from each other. However, if the spacing (pixel pitch) between the adjacent light emitting elements 30 is large enough to make the color mixture negligible, the light emitting elements 30 may not be separated from each other.

Note that, in the light emitting device 1 according to the seventh embodiment, a position at which the plug wiring line 36 and the first light absorbing film 37 are coupled to each other is offset relative to the position at which the first light shielding film 38 and the second terminal 392 are coupled to each other. This makes it possible to block a path of the leakage light from the light emitting element 30 toward the substrate 20 side, which makes it possible to further reduce leakage holes.

### <Eighth Embodiment>

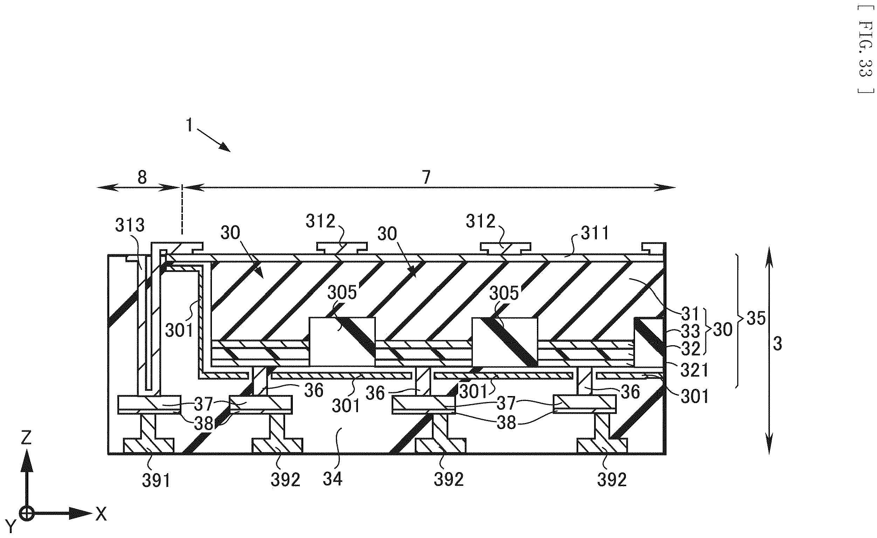

The light emitting device 1 according to the eighth embodiment of the present technology is a modification example of the light emitting device 1 according to the seventh embodiment. The light emitting device 1 includes a separation region 305 between the adjacent light emitting elements 30 as illustrated in FIG. 33. Between the light emitting elements 30, the separation region 305 is provided from the second compound semiconductor layer 32 beyond the active layer 33 up to some middle point of the first compound semiconductor layer 31. The separation region 305 is formed, for example, by implanting ions using an ion implantation method and insulating a portion of the compound semiconductor layer 300.

The light emitting device 1 according to the eighth embodiment makes it possible to achieve workings and effects similar to the workings and effects achievable by the light emitting device 1 according to the seventh embodiment.

### <Ninth Embodiment>

### [Configuration of Light Emitting Device 1]

The light emitting device 1 according to the ninth embodiment of the present technology is a modification example in which the light shielding structure of the light emitting device 1 according to the first embodiment is modified.

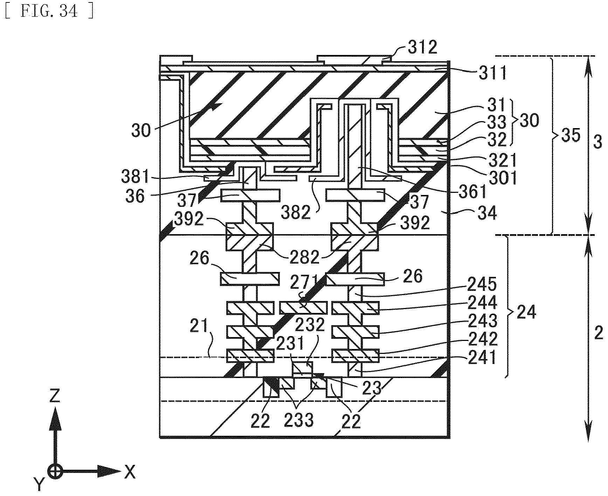

As illustrated in FIG. 34, in the substrate region 2, the light emitting device 1 includes a second light shielding film 271 on the insulated gate field effect transistor 23 that constitutes the drive circuit 21. The second light shielding film 271 covers the insulated gate field effect transistor 23. The second light shielding film 271 blocks the leakage light from the light emitting element 30 toward the insulated gate field effect transistor 23, as with the second light shielding film 26 of the light emitting device 1 according to the first embodiment.

In addition, in the light emitting body region 3, the light emitting device 1 includes a first light shielding film 381 between the second compound semiconductor layer 32 of the light emitting element 30 and the plug wiring line 36. A middle portion of the first light shielding film 381 is coupled to the second compound semiconductor layer 32 and the plug wiring line 36. A periphery portion of the first light shielding film 381, together with the plug wiring line 36, penetrates through the first light reflecting film 301, and has an increased diameter, as compared with the diameter of penetration of the first light reflecting film 301.

In addition, in the light emitting body region 3, the light emitting device 1 includes the through wiring line (plug wiring line) 361 between the light emitting elements 30. The through wiring line 361 electrically couples the first compound semiconductor layer 31 and the first terminal 391 to each other. A first light shielding film 382 having a structure similar to that of the first light shielding film 381 is provided at a portion at which the first compound semiconductor layer 31 and the through wiring line 361 are coupled to each other.

### [Workings and Effects]

The light emitting device 1 according to the ninth embodiment makes it possible to achieve workings and effects similar to the working and effects achievable by the light emitting device 1 according to the first embodiment.

In addition, the light emitting device 1 includes the first light shielding film 381, the first light shielding film 382, and the second light shielding film 271. This makes it possible to effectively block the path of the leakage light from the light emitting element 30 toward the substrate 20, which makes it possible to further reduce the leakage light.

### <First Application Example>

Next, application examples of the present technology will be described.

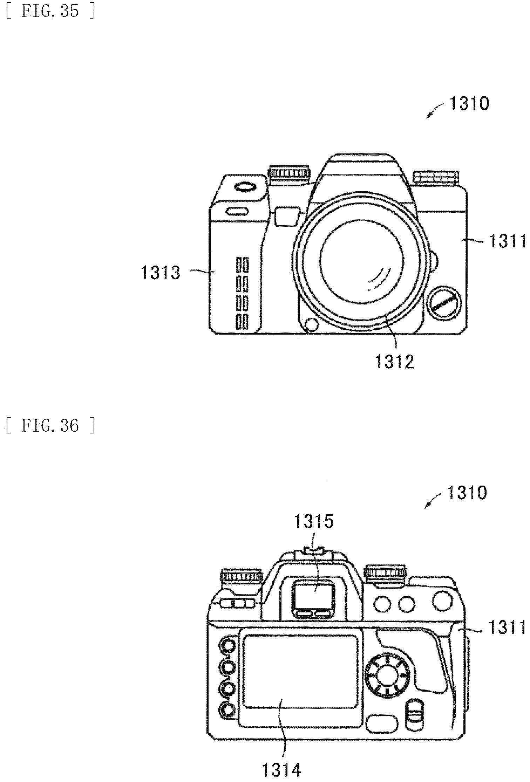

FIG. 35 is an elevation view of one example of an appearance of a digital still camera (electronic apparatus) 1310. FIG. 36 is a back view of one example of the appearance of the digital still camera 1310. This digital still camera 1310 is of a lens-exchangeable single-lens reflex type. The digital still camera 1310 includes an exchangeable image-capturing lens unit (interchangeable lens) 1312 at substantially the middle of a camera body portion (camera body) 1311 as viewed from the front, and also includes a grip portion 1313 disposed at the left side as viewed from the front. The grip portion 1313 is to be held by a photographer.

A monitor 1314 is provided at a position shifted toward the left side from the middle of the camera body portion 1311 as viewed from the back. An electronic viewfinder (eyepiece window) 1315 is provided above the monitor 1314. By looking into the electronic viewfinder 1315, the photographer visually recognizes an optical image of a subject that is guided from the image-capturing lens unit 1312, thereby being able to determine the composition. The electronic viewfinder 1315 includes the light emitting device 1.

### <Second Application Example>

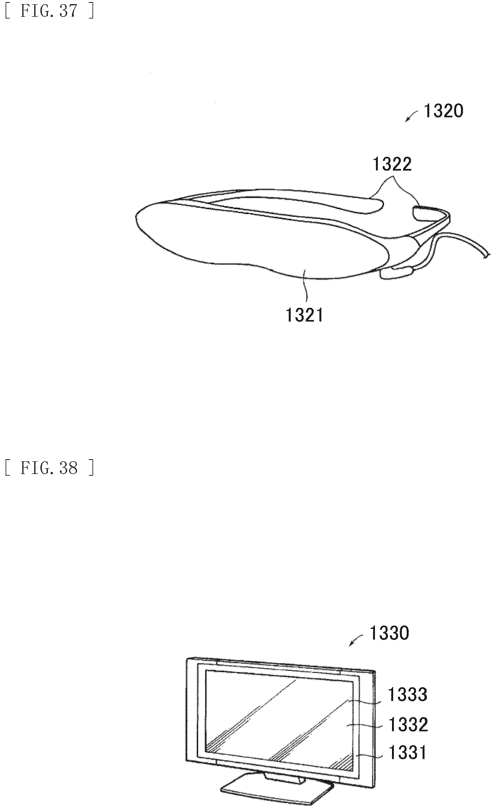

FIG. 37 is a perspective view of one example of an appearance of a head-mounted display (electronic apparatus) 1320. The head-mounted display 1320 includes, for example, temples 1322 disposed at both sides of an eyeglass-shaped displaying unit 1321. The temples 1322 allows for mounting on the user's head. The displaying unit 1321 includes the light emitting device 1.

### <Third Application Example>

FIG. 38 is a perspective view of one example of an appearance of a television apparatus (electronic apparatus) 1330. This television apparatus 1330 includes, for example, an image display screen unit 1331 including a front panel 1332 and a filter glass 1333. The image display screen unit 1331 includes the light emitting device 1.

### <Other Embodiments>

The present technology is not limited to the embodiments described above, and various modifications are possible without departing from the gist of the present technology. For example, it is possible to combine two or more of the embodiments described above.

In addition, the present technology may be applied to a single-color light emitting device that does not include any color conversion region and a method of manufacturing the light emitting device.

In the present disclosure, a plurality of light emitting elements formed from a singulated compound semiconductor layer is arranged in a row direction and a column direction. The plurality of light emitting elements is embedded in an insulating body except for a light emitting surface, and a light emitting body is thus provided. The light emitting body is joined to a substrate including a drive circuit, a first terminal, and a second terminal. The first terminal and the second terminal electrically couple the drive circuit and the plurality of light emitting elements to each other. The light emitting device is thus manufactured. This eliminates restriction in terms of the size of a substrate on which the drive circuit is mounted due to the size of the growth substrate of the light emitting elements. This makes it possible to achieve an increase in the size of the light emitting device.

### <Configuration of Present Technology>

The present technology includes the following configurations.
(1) A light emitting device including:
   a light emitting body including a plurality of light emitting elements and an insulating body in which the plurality of light emitting elements is embedded except for a light emitting surface of the plurality of light emitting elements, the plurality of light emitting elements being formed from a singulated compound semiconductor layer and arranged in a row direction and a column direction; and
   a substrate including a drive circuit, a first terminal, and a second terminal and joined to the light emitting body, the drive circuit driving the plurality of light emitting elements, the first terminal and the second terminal electrically coupling the drive circuit and the plurality of light emitting elements to each other.
(2) The light emitting device according to (1) described above, in which the plurality of light emitting elements includes a light-emitting diode including a first compound semiconductor layer, a second compound semiconductor layer, and an active layer, the first compound semiconductor layer being disposed on a side of the light emitting surface, the second compound semiconductor layer being disposed on a side of the substrate, the active layer being disposed between the first compound semiconductor layer and the second compound semiconductor layer.
(3) The light emitting device according to (2) described above, further including a first light reflecting film provided along a side surface of the first compound semiconductor layer, a side surface of the active layer, a side surface of the second compound semiconductor, and a surface, on the side of the substrate, of the second compound semiconductor, the first light reflecting film having a constant film thickness, the first light reflecting film reflecting light emitted from the plurality of light emitting elements.
(4) The light emitting device according to (3) described above, in which the first light reflecting film includes a metal film or a metallic compound film that is formed by a chemical vapor deposition method or an atomic layer deposition method.
(5) The light emitting device according to any one of (1) to (4) described above, further including:
   a transparent electrode disposed at the light emitting surface of the plurality of light emitting elements and provided integrally for the plurality of light emitting elements; and
   a reflection attenuating film disposed on and overlapping with at least the transparent electrode between the plurality of light emitting elements, the reflection attenuating film having a reflectance at an interface between the reflection attenuating film and the transparent electrode that is lower than a reflectance of the transparent electrode at an interface between the transparent electrode and an insulating material.
(6) The light emitting device according to (5) described above, in which the reflection attenuating film has electrical conductivity, and is electrically coupled to the transparent electrode.
(7) The light emitting device according to (6) described above, in which a portion of the reflection attenuating film is provided to penetrate the transparent electrode in a thickness direction.
(8) The light emitting device according to (6) described above, in which
   the reflection attenuating film extends to a peripheral region of the light emitting body, and
   the reflection attenuating film is, in the peripheral region, electrically coupled to the first terminal through a through wiring line, the through wiring line penetrating the insulating body and including a conductive material same as that of the reflection attenuating film.
(9) The light emitting device according to any one of (5) to (8) described above, in which the reflection attenuating film includes a single layer film or a combined film that includes one or more materials selected from tungsten, aluminum, titanium, tantalum, copper, and titanium nitride.
(10) The light emitting device according to any one of (1) to (9) described above, further including:
   a color conversion layer disposed on the light emitting surface for each of the plurality of light emitting elements; and
   a second light reflecting film that is disposed around a side surface of the color conversion layer and reflects light emitted from the plurality of light emitting elements.
(11) The light emitting device according to (10) described above, in which an optical lens is disposed on the color conversion layer.
(12) The light emitting device according to (3) described above, further including a plug wiring line having one end surface and another end surface in an extending direction, the one end surface penetrating the first light reflecting film in a thickness direction and being electrically coupled to the surface, on the side of the substrate, of the second compound semiconductor layer, the other end surface being electrically coupled to the second terminal.
(13) The light emitting device according to (12) described above, further including a first light absorbing film provided at an outer periphery between the first light reflecting film and the second terminal, the outer periphery intersecting with the extending direction of the plug wiring line, the first light absorbing film absorbing leakage light from between the first light reflecting film and the plug wiring line toward the side of the substrate.
(14) The light emitting device according to (13) described above, in which the first light absorbing film includes titanium nitride, cobalt, nitrogen-doped titanium oxide, tantalum nitride, or amorphous carbon.
(15) The light emitting device according to (12) described above, further including a first light shielding film provided at an outer periphery between the first light reflecting film and the second terminal, the outer periphery intersecting with the extending direction of the plug wiring line, the first light shielding film blocking leakage light from between the first light reflecting film and the plug wiring line toward the side of the substrate.
(16) The light emitting device according to (15) described above, in which the first light shielding film is provided to include aluminum, copper, tungsten, or titanium.
(17) The light emitting device according to (15) described above, in which
   the drive circuit includes a driving transistor, and
   the light emitting device further includes a second light shielding film and a second light absorbing film on a side of the plurality of light emitting elements with respect to the driving transistor, the second light shielding film blocking leakage light from the plurality of light emitting elements toward the side of the substrate, the second light absorbing film absorbing the leakage light.
(18) The light emitting device according to (17) described above, in which the second light shielding film is provided to include aluminum, copper, tungsten, or titanium.
(19) A method of manufacturing a light emitting device, the method including:
   forming a compound semiconductor layer obtained by causing a first compound semiconductor layer, an active layer, and a second compound semiconductor layer to sequentially grow on a growth substrate;
   forming a singulated compound semiconductor layer by dicing the growth substrate and the compound semiconductor layer;
   causing the second compound semiconductor layer to be opposed to a first joining surface of a first support substrate and joining the compound semiconductor layer to the first joining surface;
   peeling off the growth substrate;
   causing the first compound semiconductor layer to be opposed to a second joining surface of a second support substrate and joining the compound semiconductor layer to the second joining surface;
   removing the first support substrate;
   forming a plurality of light emitting elements from the singulated compound semiconductor layer;
   forming a light emitting body by forming an insulating body around the plurality of light emitting elements on the second support substrate;
   joining the second support substrate to a substrate on which a drive circuit, to which a first terminal and a second terminal are coupled, is mounted, in a state where the light emitting body is interposed between the substrate and the second support substrate and the second compound semiconductor layer is electrically coupled to the second terminal;
   removing the second support substrate; and
   electrically coupling the first compound semiconductor layer and the first terminal to each other.
(20) The method of manufacturing a light emitting device according to (19) described above, the method including:
   forming a transparent electrode at a light emitting surface of the plurality of light emitting elements after the removing of the second support substrate; and
   forming a reflection attenuating film on the transparent electrode between the plurality of light emitting elements in a same process as a process of the coupling of the first compound semiconductor layer and the first terminal to each other, the reflection attenuating film having a reflectance at an interface between the reflection attenuating film and the transparent electrode that is lower than a reflectance of the transparent electrode at an interface between the transparent electrode and an insulating material.
(21) A light emitting device including:
   a plurality of light emitting elements arranged along a direction of a light emitting surface;
   a transparent electrode disposed at the light emitting surface of the plurality of light emitting elements and provided integrally for the plurality of light emitting elements; and
   a reflection attenuating film disposed on and overlapping with at least the transparent electrode between the plurality of light emitting elements, the reflection attenuating film having a reflectance at an interface between the reflection attenuating film and the transparent electrode that is lower than a reflectance of the transparent electrode at an interface between the transparent electrode and an insulating material.
(22) A light emitting device including:
   a substrate on which a drive circuit to which a first terminal and a second terminal are electrically coupled is mounted;
   a light emitting body in which a plurality of light emitting elements is arranged along a direction of a light emitting surface of the plurality of light emitting elements, and an insulating body is provided around the plurality of light emitting elements except for the light emitting surface, the plurality of light emitting elements being driven by the drive circuit, the light emitting body being joined to the substrate in a state in which the plurality of light emitting elements is electrically coupled to each of the first terminal and the second terminal;
   a first light reflecting film provided along a side surface of each of the plurality of light emitting elements and along a surface, on a side of the substrate, of each of the plurality of light emitting elements;
   a plug wiring line having one end surface and another end surface in an extending direction, the one end surface penetrating the first light reflecting film in a thickness direction and being electrically coupled to the surface, on the side of the substrate, of the plurality of light emitting elements, the other end surface being electrically coupled to the second terminal.

This application claims the priority on the basis of Japanese Patent Application No. 2021-035604 filed on March 5, 2021 with Japan Patent Office, the entire contents of which are incorporated in this application by reference.

It should be understood by those skilled in the art that various modifications, combinations, sub-combinations and alterations may occur depending on design requirements and other factors insofar as they are within the scope of the appended claims or the equivalents thereof.

## Claims

1. Alight emitting device comprising:
a light emitting body including a plurality of light emitting elements and an insulating body in which the plurality of light emitting elements is embedded except for a light emitting surface of the light emitting elements, the plurality of light emitting elements being formed from a singulated compound semiconductor layer and arranged in a row direction and a column direction; and
a substrate including a drive circuit, a first terminal, and a second terminal and joined to the light emitting body, the drive circuit driving the plurality of light emitting elements, the first terminal and the second terminal electrically coupling the drive circuit and the plurality of light emitting elements to each other.

2. The light emitting device according to claim 1, wherein the plurality of light emitting elements comprises a light-emitting diode including a first compound semiconductor layer, a second compound semiconductor layer, and an active layer, the first compound semiconductor layer being disposed on a side of the light emitting surface, the second compound semiconductor layer being disposed on a side of the substrate, the active layer being disposed between the first compound semiconductor layer and the second compound semiconductor layer.

3. The light emitting device according to claim 2, further comprising a first light reflecting film provided along a side surface of the first compound semiconductor layer, a side surface of the active layer, a side surface of the second compound semiconductor layer, and a surface, on the side of the substrate, of the second compound semiconductor layer, the first light reflecting film having a constant film thickness, the first light reflecting film reflecting light emitted from the plurality of light emitting elements.

4. The light emitting device according to claim 3, wherein the first light reflecting film comprises a metal film or a metallic compound film that is formed by a chemical vapor deposition method or an atomic layer deposition method.

5. The light emitting device according to claim 1, further comprising:
a transparent electrode disposed at the light emitting surface of the plurality of light emitting elements and provided integrally for the plurality of light emitting elements; and
a reflection attenuating film disposed on and overlapping with at least the transparent electrode between the plurality of light emitting elements, the reflection attenuating film having a reflectance at an interface between the reflection attenuating film and the transparent electrode that is lower than a reflectance of the transparent electrode at an interface between the transparent electrode and an insulating material.

6. The light emitting device according to claim 5, wherein the reflection attenuating film has electrical conductivity, and is electrically coupled to the transparent electrode.

7. The light emitting device according to claim 6, wherein a portion of the reflection attenuating film is provided to penetrate the transparent electrode in a thickness direction.

8. The light emitting device according to claim 6, wherein
the reflection attenuating film extends to a peripheral region of the light emitting body, and
the reflection attenuating film is, in the peripheral region, electrically coupled to the first terminal through a through wiring line, the through wiring line penetrating the insulating body and including a conductive material same as that of the reflection attenuating film.

9. The light emitting device according to claim 5, wherein the reflection attenuating film includes a single layer film or a combined film that includes one or more materials selected from tungsten, aluminum, titanium, tantalum, copper, and titanium nitride.

10. The light emitting device according to claim 1, further comprising:
a color conversion layer disposed on the light emitting surface for each of the plurality of light emitting elements; and
a second light reflecting film that is disposed around a side surface of the color conversion layer and reflects light emitted from the plurality of light emitting elements.

11. The light emitting device according to claim 10, wherein an optical lens is disposed on the color conversion layer.

12. The light emitting device according to claim 3, further comprising a plug wiring having one end surface and another end surface in an extending direction, the one end surface penetrating the first light reflecting film in a thickness direction and being electrically coupled to the surface, on the side of the substrate, of the second compound semiconductor layer, the other end surface being electrically coupled to the second terminal.

13. The light emitting device according to claim 12, further comprising a first light absorbing film provided at an outer periphery between the first light reflecting film and the second terminal, the outer periphery intersecting with the extending direction of the plug wiring line, the first light absorbing film absorbing leakage light from between the first light reflecting film and the plug wiring line toward the side of the substrate.

14. The light emitting device according to claim 13, wherein the first light absorbing film includes titanium nitride, cobalt, nitrogen-doped titanium oxide, tantalum nitride, or amorphous carbon.

15. The light emitting device according to claim 12, further comprising a first light shielding film provided at an outer periphery between the first light reflecting film and the second terminal, the outer periphery intersecting with the extending direction of the plug wiring, the first light shielding film blocking leakage light from between the first light reflecting film and the plug wiring line toward the side of the substrate.

16. The light emitting device according to claim 15, wherein the first light shielding film is provided to include aluminum, copper, tungsten, or titanium.

17. The light emitting device according to claim 15, wherein
the drive circuit includes a driving transistor, and
the light emitting device further comprises a second light shielding film and a second light absorbing film on a side of the plurality of light emitting elements with respect to the driving transistor, the second light shielding film blocking leakage light from the plurality of light emitting elements toward the side of the substrate, the second light absorbing film absorbing the leakage light.

18. The light emitting device according to claim 17, wherein the second light shielding film is provided to include aluminum, copper, tungsten, or titanium.

19. A method of manufacturing a light emitting device, the method comprising:
forming a compound semiconductor layer obtained by causing a first compound semiconductor layer, an active layer, and a second compound semiconductor layer to sequentially grow on a growth substrate;
forming a singulated compound semiconductor layer by dicing the growth substrate and the compound semiconductor layer;
causing the second compound semiconductor layer to be opposed to a first joining surface of a first support substrate and joining the compound semiconductor layer to the first joining surface;
peeling off the growth substrate;
causing the first compound semiconductor layer to be opposed to a second joining surface of a second support substrate and joining the compound semiconductor layer to the second joining surface;
removing the first support substrate;
forming a plurality of light emitting elements from the singulated compound semiconductor layer;
forming a light emitting body by forming an insulating body around the plurality of light emitting elements on the second support substrate;
joining the second support substrate to a substrate on which a drive circuit, to which a first terminal and a second terminal are coupled, is mounted, in a state where the light emitting body is interposed between the substrate and the second support substrate and the second compound semiconductor layer is electrically coupled to the second terminal;
removing the second support substrate; and
electrically coupling the first compound semiconductor layer and the first terminal to each other.

20. The method of manufacturing a light emitting device according to claim 19, the method comprising:
forming a transparent electrode at a light emitting surface of the plurality of light emitting elements after the removing of the second support substrate; and
forming a reflection attenuating film on the transparent electrode between the light emitting elements in a same process as a process of the coupling of the first compound semiconductor layer and the first terminal to each other, the reflection attenuating film having a reflectance at an interface between the reflection attenuating film and the transparent electrode that is lower than a reflectance of the transparent electrode at an interface between the transparent electrode and an insulating material.
